# EUROPEAN PATENT SPECIFICATION

(11) **EP 2 160 649 B1**
(45) Date of publication and mention of the grant of the patent: **26.07.2017**
(21) Application number: 08768325.6
(22) Date of filing: 11.06.2008
(51) Int. Cl.: G03F 7/00, G03F 7/027, G03F 7/038

(54) **CLEAR AND COLORLESS THREE-DIMENSIONAL ARTICLES MADE VIA STEREOLITHOGRAPHY AND METHOD OF MAKING SAID ARTICLES**
TRANSPARENTE UND FARBLOSE DREIDIMENSIONALE MITTELS STEREOLITHOGRAFIE HERGESTELLTE ARTIKEL UND VERFAHREN ZUR HERSTELLUNG DIESER ARTIKEL
ARTICLES TRIDIMENSIONNELS TRANSLUCIDES ET INCOLORES FABRIQUES PAR LE BIAIS D'UNE STEREOLITHOGRAPHIE ET PROCEDE DE FABRICATION DESDITS ARTICLES

(30) Priority: 27.06.2007 US 819508
(43) Date of publication of application: 10.03.2010
(73) Proprietor: DSM IP Assets B.V., 6411 TE Heerlen (NL)
(72) Inventor: SARMAH, Satyendra, Kumar, Chicago, IL 60634 (US); ZARAS, Kevin, Andrew, Huntley, IL 60142 (US)
(74) Representative: V.O.
(86) International application number: PCT/US2008/007267
(87) International publication number: WO 2009/005576

(56) References cited:
- EP-A- 0 535 828
- WO-A-03/093901
- US-A1- 2003 104 313
- US-A1- 2005 142 479

## Description

### Field of the Invention

The present invention relates to three-dimensional articles made using a radiation curable resin and stereolithography equipment.

### Background of the Invention

The production of cured three-dimensional articles of complex shape by means of stereolithography has been known for a number of years. In this technique the desired shaped article is built up from a radiation-curable composition with the aid of a recurring, alternating sequence of two steps (a) and (b). In step (a), a layer of the radiation-curable composition, one boundary of which is the surface of the composition, is cured with the aid of appropriate imaging radiation, preferably imaging radiation from a computer-controlled scanning laser beam, within a surface region which corresponds to the desired cross-sectional area of the shaped article to be formed, and in step (b) the cured layer is covered with a new layer of the radiation-curable composition, and the sequence of steps (a) and (b) is repeated until a so-called green model of the desired shape is finished. This green model is, in general, not yet fully cured and may therefore be subjected to post-curing, though such post curing is not required.

With known resins, it is typical that the final color and opacity develops in the three dimensional article as it is cured. Throughout this patent application the term color is defined as follows: Color (or colour, alternative spelling) is the visual perceptual property corresponding in humans to the categories called red, yellow, white, etc. Color derives from the spectrum of light (distribution of light energy versus wavelength) interacting in the eye with the spectral sensitivities of the light receptors. Color categories and physical specifications of color are also associated with objects, materials, light sources, etc., based on their physical properties such as light absorption, reflection, or emission spectra.

Typically, only features of the composition of light that are detectable by humans (wavelength spectrum from 400 nm to 700 nm, roughly) are included, thereby objectively relating the psychological phenomenon of color to its physical specification. Because perception of color stems from the varying sensitivity of different types of cone cells in the retina to different parts of the spectrum, colors may be defined and quantified by the degree to which they stimulate these cells. {Source, Wikipedia, May 24 2007, http://en.wikipedia.org/wiki/Color.}

In optics, transparency is the property of allowing light to pass. Throughout this patent application, the word "clear" means "transparent" as it applies to the amount of light allowed to pass through the three dimensional shaped article. Transparent materials can be seen through; that is, they allow clear images to pass. The opposite property is opacity. Translucent materials allow light to pass through them only diffusely, that is, the material distorts the image. Also known as diaphaneity, a commonly used term in mineralogy. {Source: Wikepedia, May 24 2007, http://en.wikipedia.org/wiki/Transparency_%28optics%29}

Throughout this patent application, "Opacity" is defined as follows: Opacity is the state of being impenetrable to light. An opaque object is neither transparent (allowing all light to pass through) nor translucent (allowing some light to pass through). When light strikes an interface between two substances, some of the light is reflected, some is absorbed, and the rest is transmitted. An opaque substance transmits very little light, and therefore reflects or absorbs most of it. Both mirrors and jet are opaque. Opacity depends on the frequency of the light being considered. For instance, some kinds of glass, while completely transparent in the visual range, are largely opaque to ultraviolet light. More extreme frequency-dependence is visible in the absorption lines of cold gases. In general, a material tends to emit light in the same proportions as it absorbs it; this is the reason for the equivalence of absorption and emission lines. {Source: Wikepedia, May 24 2007, http://en.wikipedia.org/wiki/Opacity_%28optics%29}

The final color of the three dimensional article may or may not match the color of the liquid uncured resin. For instance, it is common for the uncured, liquid resin to display one color and then the three-dimensional article made using the liquid resin to develop a different color or develop a different shade of the original color. Persons of ordinary skill in the art understand that the final color of the shaped articles develops under cure and is a result of the components chosen to be present in the liquid resin.

The color development can be a desired feature of the product and a person of ordinary skill in the art knows how to select color imparting additives such as dyes and pigments to produce a cured three dimensional article with the desired color. See Published U.S. Patent Application US2004/0170923, "Colored Stereolithographic Resins", Published September 2, 2004, and Published U.S. Patent Application US2005/0142479, "Radiation Curable Resin Composition for Making Colored Three Dimensional Objects", Published June 30, 2005.

The color development can be undesired. This occurs when a colorless shaped article is desired, but the standard liquid resin used to make the shaped article has components in it that develop undesired color under cure.

Meeting the challenge of producing three dimensional articles made using a liquid radiation curable material with improved clarity is described in U.S. Patent No. 6,811,937, Issued November 2, 2004. This patent does not include the word color, so the patent is silent about the color of the three dimensional shaped articles made.

It is known that certain materials can be added to the liquid resin so that the cured three dimensional articles made using that liquid resin is clear and nearly colorless. However, it has been found that these certain added materials have a deleterious effect upon the physical properties of the cured three dimensional articles.

US-A-2003/0 104 313 is directed to radiation-curable compositions comprising a ctaionically curable compound and a free radical polymerisable compound. Ethoxylated neopentylglycol diacrylate in the composition has a clarifying effects.

US-A-2005/0 142 479 is directed to resin compositions that are suitable for making coloured three-dimensional objects. The document is silent with respect to pigments.

EP-A-0 535 828 relates to a photopolymerisable resin having high sensitivity to active radiation. This document fails to disclose a radiation curable resin that comprises a pigment.

WO-A-03/093901 is directed to a radiation curable resin composition that, after full cure, shows improved resistance to moisture or humidity. This document fails to disclose a radiation curable resin that comprises a pigment.

It would be desirable to develop a liquid radiation curable resin that develops into a three-dimensional shaped article using a stereolithography process wherein the three-dimensional shaped article has desirable physical properties and is clear and colorless.

### Summary Of The Invention

The first aspect of the instant claimed invention is a liquid radiation curable resin comprising:
a) one or more di- or multi-functional acrylates;
b) one or more epoxy compounds, wherein at least one of said epoxy compounds is selected from the group consisting of cycloaliphatic epoxy compounds, hydrogenated bisphenol A diglycidylether and mixtures thereof;
c) a free radical photoinitiator;
d) a cationic photoinitiator; and
e) a color masking agent selected from the group consisting of blue, violet, red, yellow, orange and green pigments:
   wherein said liquid radiation curable resin, when cured as described herein, has the following properties
      i) a clarity and transmittance of greater than 67% as measured by UV-Visible spectrophotometer in the 400-500 nm range; and
      ii) a lack of color as measured by a b* value of between minus 0.5 and positive 2.5 in the CIELAB color space using a spectrophotometer in the visible wavelengths of 400-750 nm.

The second aspect of the instant claimed invention is a liquid radiation curable resin comprising:
a) an acrylate component, wherein the acrylate component is selected from the group consisting of one or more mono, di- or multi-functional acrylates and one or more urethane acrylate oligomers;
b) a free radical photoinitiator; and
c) a color masking agent selected from the group consisting of blue, violet, red, yellow, orange and green pigments;
   wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The third aspect of the instant claimed invention is a clear and colorless, three-dimensional article made from a liquid radiation curable resin comprising:
a) one or more di- or multi-functional acrylates;
b) one or more epoxy compounds, wherein at least one of said epoxy compounds is selected from the group consisting of cycloaliphatic epoxy compounds, hydrogenated bisphenol A diglycidylether and mixtures thereof;
c) a free radical photoinitiator;
d) a cationic photoinitiator; and
e) a color masking agent, selected from the group consisting of blue, violet, red, yellow, orange and green pigments;
   wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The fourth aspect of the instant claimed invention is a clear and colorless, three-dimensional article made from a liquid radiation curable resin comprising:
a) an acrylate component, wherein the acrylate component is selected from the group consisting of one or more mono, di- or multi-functional acrylates and one or more urethane acrylate oligomers;
b) a free radical photoinitiator; and
v) a color masking agent selected from the group consisting of blue, violet, red, yellow, orange and green pigments; wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

### Brief Description of the Drawings

Figure 1 is a matrix describing the desirable and undesirable features of the components in radiation curable liquid resins including acrylates and epoxides; or acrylates, epoxides and oxetanes; or acrylates, epoxides, oxetanes and polyols.
Figure 2 is a matrix describing the desirable and undesirable features of the components in radiation curable liquid resins including acrylates.

### Detailed Description of the Invention

Disclosed is a method of creating a liquid radiation curable resin that is capable of being cured into clear and colorless three-dimensional articles, comprising the steps of
a) selecting the items of choice from each category of possible components to use in formulating the liquid radiation curable resin;
b) determining the anticipated color and clarity profile of cured three-dimensional stereolithographic articles made using the liquid radiation curable resin of element a); and then
c) selecting the color masking agent for the liquid radiation curable resin that provide for the clear and colorless appearance of cured three-dimensional stereolithographic articles made from the liquid radiation curable resin;
   wherein said clear and colorless three dimensional articles have the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The components that are typically used to formulate liquid radiation curable resins are known to people of ordinary skill in the art. These components are divided into categories such as: one or more acrylates (for all acrylate these can be mono, di- or multifunctional acrylates or urethane acrylate oligomers; for acrylates and other cationic materials these can be di- or multifunctional acrylates); one or more epoxy compounds, wherein at least one of said epoxy compounds is selected from the group consisting of cycloaliphatic epoxy compounds, hydrogenated bisphenol A diglycidylether and mixtures thereof; Optionally, an oxetane; Optionally one or more Hydroxyl-Functional Compounds; Optionally, one or more Additives selected from the group consisting of light stabilizer/UV absorbers; antioxidants; acid stabilizers; wetting agents; air release agents; a free radical photoinitiator (always required); and a cationic photoinitiator (only required when cationic curable components, such as epoxies are present).

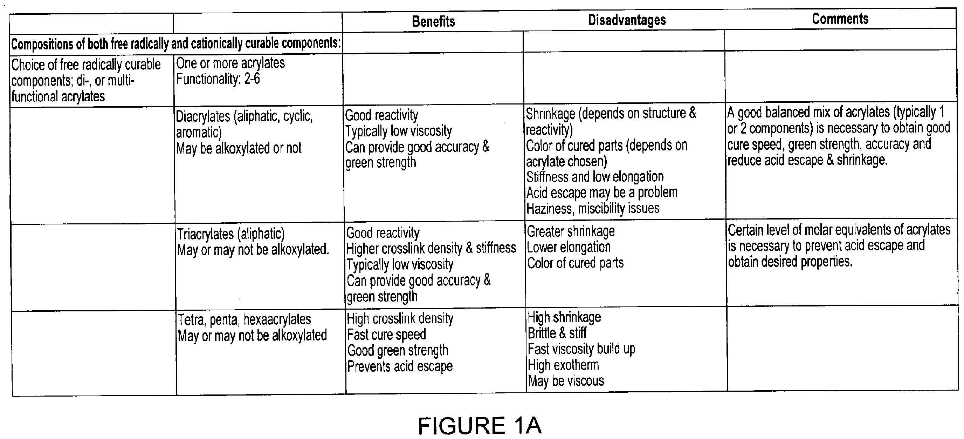

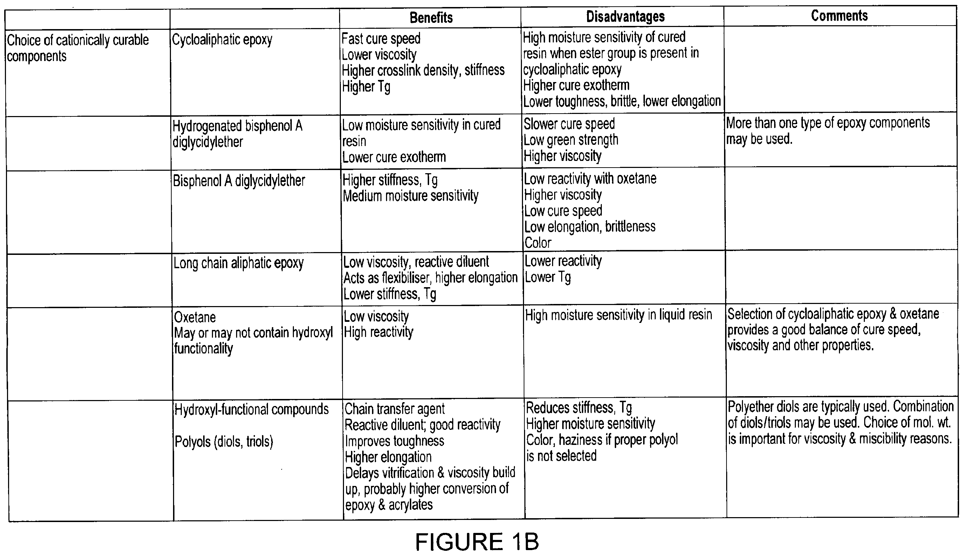

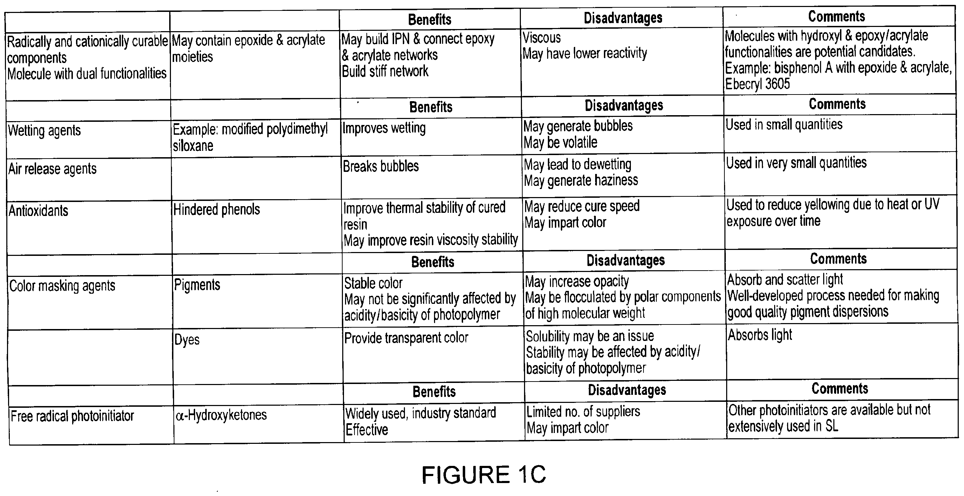

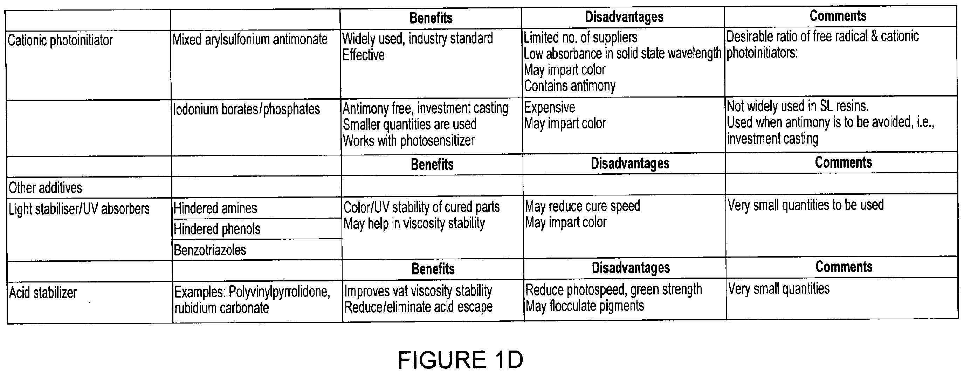

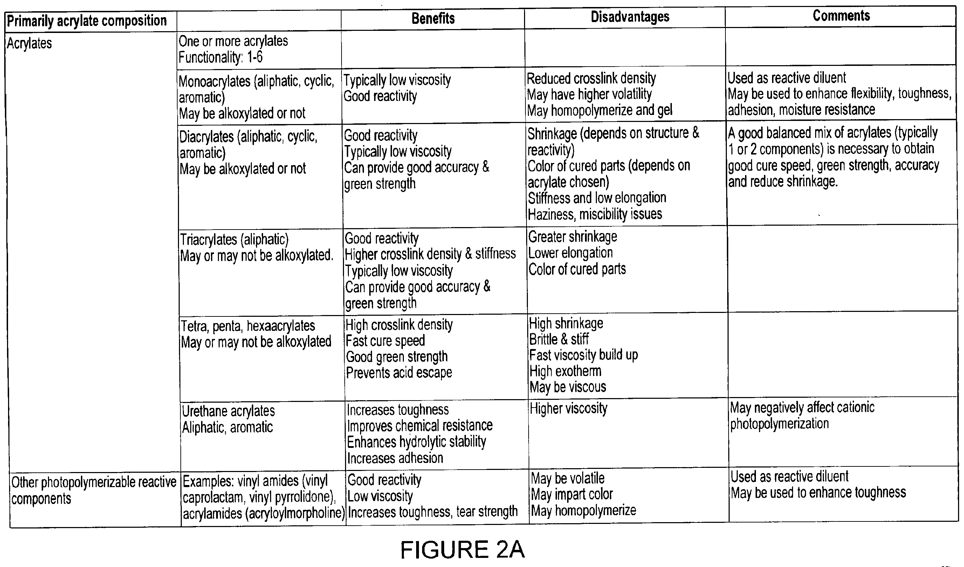

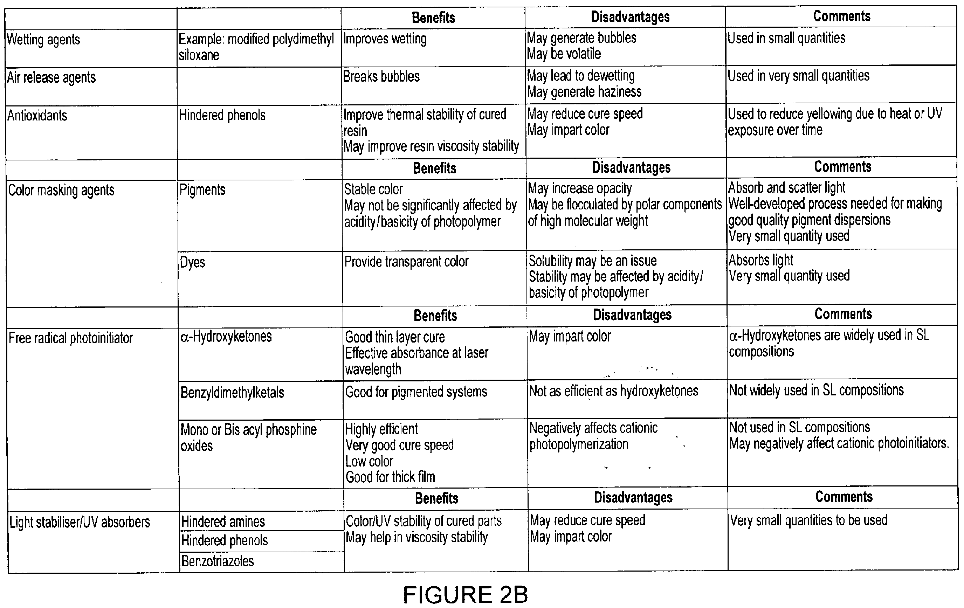

These categories of components have been described thoroughly in published documents such as the Published U.S. Patent Application US2004/0170923, "Colored Stereolithographic Resins", Published September 2, 2004, and Published U.S. Patent Application US2005/0142479, "Radiation Curable Resin Composition for Making Colored Three Dimensional Objects", Published June 30, 2005. In selecting the components to be used in the liquid radiation curable resin, the information compiled in the Matrix of Figure 1 and the Matrix of Figure 2 can be used to guide the formulator in selecting the required components: the acrylates or the acrylates and epoxies and the required photoinitiators.

After the selection of the required components, acrylates are used by themselves when the cured three-dimensional article may be soft and sticky (low modulus), acrylates may be used by themselves when the cured three-dimensional article may be hard and brittle(high modulus) and acrylates are used in combination with epoxy(ies) when the cured three-dimensional article must cure to a non-sticky, non-soft finished state with the desired modulus; the required photo-initiators are selected, as acrylates require the use of free-radical initiators and epoxies require the use of cationic photoinitiators.

Once the required components are selected, the remainder of the optional components are selected according to the properties outlined in the matrix and the positive and negative aspects of each component.

The second step in the method is to cure the liquid radiation curable resin into a solid three-dimensional article and determine the color and clarity profile of the cured article. This may be done visually, with the human eye the deciding factor, or it may be done using the test methods described herein.

When the color and clarity profile of the cured article is not as desired, one or more color masking agents, selected from the group consisting of commercially available dyes and pigments, may be selected and added to the liquid radiation curable resin. The liquid radiation curable resin is then cured into another solid three-dimensional article and the color and clarity profile of this article is also determined. This iterative process is continued, with the selection of color masking agents dependent upon the natural and modified color and clarity profile of the three dimensional cured article. After the desired level of color and clarity is achieved, the physical properties of the three dimensional cured article are measured and if physical properties are as desired, the process is concluded. If the three dimensional cured article does not have the desired physical properties, then the liquid radiation curable resin is reformulated using the information presented in Figure 1 and in Figure 2.

The clarity and transmittance is measured using a UV-Visible spectrophotometer in the 400-500 nm range on three dimensional articles selected so that the samples were selected so as to not have any internal defects. A measured clarity and transmittance of greater than 67% is present. The measured clarity and transmittance can be greater than 70%. The measured clarity and transmittance can be greater than 75%.

The color is measured according to the CIELAB color space b* value using a spectrophotometer in the visible wavelengths of 400-750 nm. The lower measurement of color, b* value, is minus 0.5 (-0.5), preferably zero (0) and more preferably positive 0.75 (+0.75). The upper measurement of color, b* value, is positive 2.5 (+2.5), preferably positive 2.0 (+2.0) and more preferably positive 1.75 (+1.75).

In practice, a measured lack of color, as measured by a b* value of between minus 0.5 and positive 2.5 is present. It is preferred that there be a measured lack of color, as measured by a b* value of between 0 and positive 2.0. It is preferred that there be a measured lack of color, as measured by a b* value of between positive 0.75 and positive 1.75.

The first aspect of the instant claimed invention is a liquid radiation curable resin comprising:
a) one or more di- or multi-functional acrylates;
b) one or more epoxy compounds, wherein at least one of said epoxy compounds is selected from the group consisting of cycloaliphatic epoxy compounds, hydrogenated bisphenol A diglycidylether and mixtures thereof;
c) optionally, an oxetane;
d) optionally one or more hydroxyl-functional compounds;
e) optionally, one or more additives selected from the group consisting of
   i) light stabilizer/UV absorbers;
   ii) antioxidants;
   iii) acid stabilizers;
   iv) wetting agents;
   v) air release agents;
g) a free radical photoinitiator;
h) a cationic photoinitiator; and
i) a color masking agent selected from the group consisting of blue, violet, red, yellow, orange and green pigments; wherein said liquid radiation curable resin, when cured as described, herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The resin composition of the present invention comprises one or more di- or multifunctional acrylates. Difunctional acrylates may be aliphatic or aromatic.

Examples of suitable aliphatic diacrylates are cyclohexane dimethanol di(meth)acrylate, alkoxylated hexanediol diacrylate, alkoxylated cyclohexane dimethanol di(meth)acrylate, neopentyl glycol di(meth)acrylate, alkoxylated neopentyl glycol diacrylate, 1,6 hexanediol di(meth)acrylate, ethylene glycol diacrylate, tripropylene glycol diacrylate, hexylene glycol diacrylate, diethylene glycol diacrylate, tetraethylene glycol diacrylate, polyethylene glycol di(meth)acrylate, propoxylated neopentyl glycol diacrylate.

In one embodiment of the acrylate plus epoxy composition, the composition comprises from 1 wt.% to 25 wt.% of the aliphatic diacrylate, relative to the total weight of the composition. In another embodiment, the composition comprises from 3 wt.% to 15 wt.% of the aliphatic diacrylate, relative to the total weight of the composition. In another embodiment the composition comprises about 5 wt.% of the aliphatic diacrylate.

Examples of suitable aromatic diacrylates are bisphenol A di(meth)acrylate, bisphenol F di(meth)acrylate, bisphenol S di(meth)acrylate, EO-modified bisphenol A di(meth)acrylate, PO-modified bisphenol A di(meth)acrylate, EO-modified bisphenol F di(meth)acrylate, PO-modified bisphenol F di(meth)acrylate, EO-modified bisphenol S di(meth)acrylate, PO-modified bisphenol S di(meth)acrylate.

In one embodiment, the preferred aromatic diacrylate is bisphenol A diglycidylether diacrylate which is available as Ebecryl 3700 from Cytec.

In one embodiment of the acrylate plus epoxy composition, the composition comprises from 1 wt.% to 10 wt.% of the aromatic diacrylate, relative to the total weight of the composition. In another embodiment, the composition comprises from 3wt.% to 8 wt.% of the aromatic diacrylate, relative to the total weight of the composition. In another embodiment the composition comprises about 5 wt.% of the aromatic diacrylate.

Examples of suitable triacrylates are trimethylolpropane tri(meth)acrylate, Ethoxylated trimethylolpropane triacrylate, propoxylated trimethylolpropane triacrylate, pentaerythritol triacrylate, tris(2-hydroxy ethyl) isocyanurate triacrylate, propoxylated glyceryl triacrylate, trifunctional (meth)acrylate ester. In one embodiment, the preferred triacrylate is propoxylated trimethylolproprane triacrylate which is available from Sartomer as SR492.

In one embodiment of the acrylate plus epoxy composition, the amount of the triacrylate is from 0 wt.% to 25 wt.%, relative to the total weight of the composition. In another embodiment the amount of the triacrylate is from 5 wt.% to 15 wt.%, relative to the total weight of the composition. In another embodiment the amount of the triacrylate is about 12 wt.%.

The composition of the instant claimed invention comprises one or more epoxy compounds, wherein at least one of said epoxy compounds is selected from the group consisting of cycloaliphatic epoxy compounds, hydrogenated bisphenol A diglycidylether and mixtures thereof. The epoxy compounds, are cationically curable, by which is meant that polymerization and/or crosslinking of the epoxy group may be initiated by cations.

An epoxy compound is a compound that possesses at least one 1,2-epoxide group in the molecule. By "1,2-epoxide" is meant the three-membered ring having a structure represented by

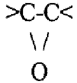

A cycloaliphatic diepoxy compound is a compound containing an aliphatic moiety having at least one cyclic structure and two 1,2-epoxide groups.

Examples of compounds in which the 1,2- epoxide groups are part of an cycloaliphatic ring system include bis(2,3-epoxycyclopentyl)ether; 2,3-epoxycyclopentyl glycidyl ether, 1,2-bis(2,3-epoxycyclopentyloxy)ethane; bis(4-hydroxycyclohexyl)methane diglycidylether, 2,2-bis(4-hydroxycyclohexyl)propane diglycidylether; 3,4-epoxycyclohexylmethyl-3',4'-epoxycyclohexanecarboxylate; 3,4-epoxy-6-methylcyclohexylmethyl 3,4-epoxy-6-methylcyclohexanecarboxylate; di(3,4-epoxycyclohexylmethyl)hexanedioate; di(3,4-epoxy-6-methylcyclohexylmethyl)hexanedioate; ethylenebis(3,4-epoxycyclohexane-carboxylate, ethanediol di(3,4-epoxycyclohexylmethyl)ether; vinylcyclohexene dioxide; dicyclopentadiene diepoxide or 2-(3,4-epoxycyclohexyl-5,5-spiro-3,4-epoxy-)cyclohexane-1,3-dioxane, and combinations thereof.

Especially preferred cycloaliphatic diepoxides are 3,4-epoxycyclohexylmethyl-3,4-epoxycyclohexanecarboxylate, 3,4-epoxy-6-methylcyclohexylmethyl-3,4-epoxy-6-methylcyclohexanecarboxylate, di(3,4-epoxycyclohexylmethyl)hexanedioate, di(3,4-epoxy-6-methylcyclohexylmethyl)hexanedioate, ethylenebis(3,4-epoxycyclohexanecarboxylate), ethanediol-di(3,4-epoxycyclohexylmethyl) ether, 2-(3,4-epoxycyclohexyl-5,5 -spiro-3,4-epoxy)cyclohexane-1,3-dioxane, and combinations thereof.

There are additional lists of epoxy compounds in U.S. Patent 7,183,040 B2.

The preferred cycloaliphatic epoxy is 3,4-epoxycyclohexylmethyl-3,4-epoxycyclohexanecarboxylate, which is available as Celloxide 202IP from Chitec Technology(distributor), Daicel Chemical Industries(manufacturer).

Hydrogenated bisphenol A diglycidylether is available from Hexion as Eponex 1510 and is available from CVC Chemicals as Epalloy 5000.

In one embodiment the total amount of the epoxy compound is from 10 wt.% to 65 wt.%, relative to the total weight of the composition. In another embodiment the amount is from 40 wt.% to 60 wt.%, relative to the total weight of the composition. In another embodiment the amount of the epoxy compound is about 55 wt. %.

There must be a measurable amount of either cycloaliphatic epoxy or hydrogenated bisphenol A diglycidylether in the liquid resin composition. Typically, both cycloaliphatic epoxy and hydrogenated bisphenol A diglycidylether are both present in the liquid resin composition in order to create a liquid curable resin composition that will cure into three dimensional shaped articles that have desired physical properties and are clear and colorless.

The composition of the present invention optionally comprises an oxetane.

An oxetane compound comprises at least one oxetane ring shown by the following formula (1).

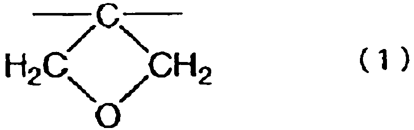

The oxetane compound can be polymerized or crosslinked by irradiation with light in the presence of a cationic photoinitiator. The oxetane, or oxetane compound, may comprise one or more oxetane rings.

Examples of oxetanes having one oxetane ring in the molecule, are shown by the following formula (2): 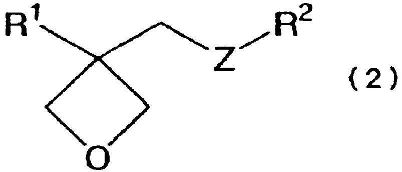 wherein Z represents an oxygen atom or sulphur atom; R¹ represents a hydrogen atom, fluorine atom, an alkyl group having 1-6 carbon atoms such as a methyl group, ethyl group, propyl group, and butyl group, a fluoroalkyl group having 1-6 carbon atoms such as trifluoromethyl group, perfluoroethyl group, and perfluoropropyl group, an aryl group having 6-18 carbon atoms such as a phenyl group and naphthyl group, a furyl group, or a thienyl group; and R² represents a hydrogen atom, an alkyl group having 1-6 carbon atoms for example a methyl group, ethyl group, propyl group, and butyl group, an alkenyl group having 2-6 carbon atoms for example a 1-propenyl group, 2-propenyl group, 2-methyl-1-propenyl group, 2-methyl-2-propenyl group, 1-butenyl group, 2-butenyl group, and 3-butenyl group, an aryl group having 6-18 carbon atoms for example a phenyl group, naphthyl group, anthranyl group, and phenanthryl group, a substituted or unsubstituted aralkyl group having 7-18 carbon atoms for example a benzyl group, fluorobenzyl group, methoxy benzyl group, phenethyl group, styryl group, cynnamyl group, ethoxybenzyl group, a group having other aromatic rings for instance an aryloxyalkyl for example a phenoxymethyl group and phenoxyethyl group, an alkylcarbonyl group having 2-6 carbon atoms for example an ethylcarbonyl group, propylcarbonyl group, butylcarbonyl group, an alkoxy carbonyl group having 2-6 carbon atoms for example an ethoxycarbonyl group, propoxycarbonyl group, butoxycarbonyl group, an N-alkylcarbamoyl group having 2-6 carbon atoms such as an ethylcarbamoyl group, propylcarbamoyl group, butylcarbamoyl group, pentylcarbamoyl group, or a polyethergroup having 2-1000 carbon atoms.

Examples of oxetane compounds having two oxetane rings in the molecule are compounds shown by the following formula (3): 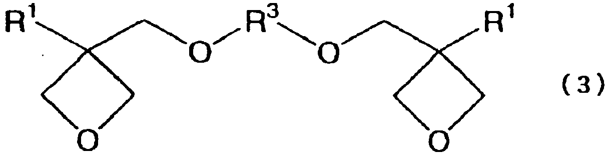 wherein R¹ is the same as defined for the above formula (2); R³ represents a linear or branched alkylene group having 1-20 carbon atoms for example an ethylene group, propylene group, and butylene group, a linear or branched poly(alkyleneoxy) group having 1-120 carbon atoms for example a poly(ethyleneoxy) group and poly(propyleneoxy) group, a linear or branched unsaturated hydrocarbon group for example a propenylene group, methylpropenylene group, and butenylene group; and R³ may be a polyvalent group selected from groups shown by the following formulas (4), (5), and (6): 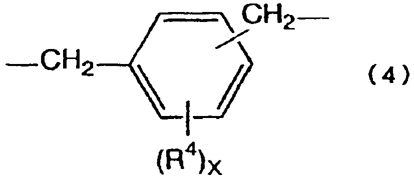 wherein R⁴ represents an alkyl group having 1-4 carbon atoms, an alkoxy group having 1-4 carbon atoms, a halogen atom for example a chlorine atom or bromine atom, a nitro group, cyano group, mercapto group, carboxyl group, or carbamoyl group, and x is an integer from 0-4; 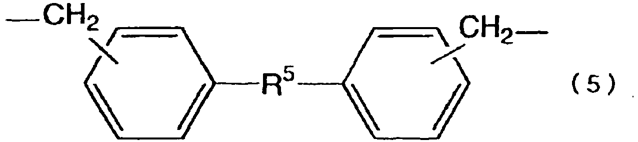 wherein R⁵ represents an oxygen atom, sulphur atom, methylene group, -NH-, -SO-, -SO2-, - C(CF₃)₂-, or -C(CH₃)₂-; 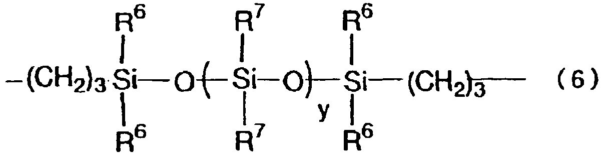 wherein R⁶ represents an alkyl group having 1-4 carbon atoms or an aryl group having 6-18 carbon atoms for example a phenyl group or naphthyl group, y is an integer from 0-200, and R⁷ represents an alkyl group having 1-4 carbon atoms, an aryl group having 6-18 carbon atoms for example a phenyl group or naphthyl group, or a group shown by the following formula (7): 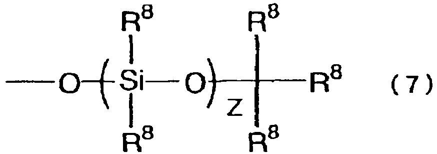 wherein R⁸ represents an alkyl group having 1-4 carbon atoms or an aryl group having 6-18 carbon atoms for example a phenyl group or naphthyl group, and z is an integer from 0 to 100.

In this patent application, there is no formula (8). The next three formulas are (9), (10) and (11).

Specific examples of the compounds having two oxetane rings in the molecule are compounds shown by the following formulas (9), and (10).

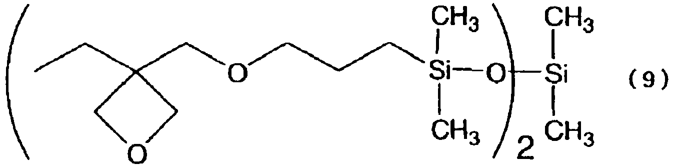

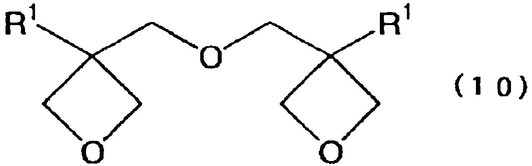

In the formula (10), R¹ is the same as defined for the above formula (2).

Examples of the compounds having three or more oxetane rings in the molecule are compounds represented by formula (11): 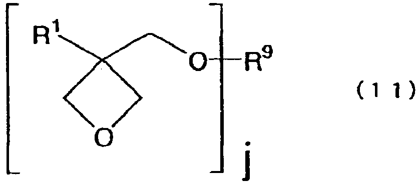 wherein R¹ is the same as defined for the above formula (2); R⁹ represents an organic group with a valence of 3-10.

In this patent application, there is no formula (12), (13), (14), (15), (16) or (17). The next formulas are (18), (19) and (20), (21) and (22).

Specific examples of compounds having three or more oxetane rings in the molecule are compounds shown by the following formula (18):

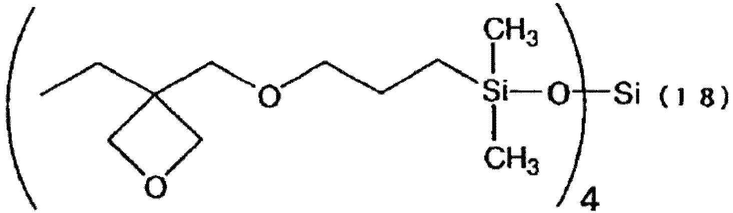

Compounds shown by the following formula (19) may comprise 1-10 oxetane rings: 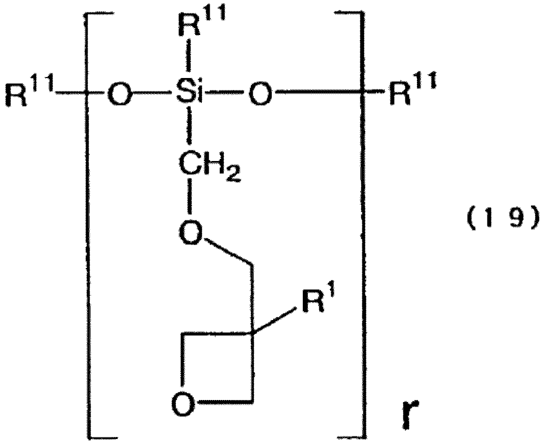 wherein R¹ is the same as defined for the formula (2), R⁸ is the same as defined for the formula (7), R¹¹ represents an alkyl group having 1-4 carbon atoms or trialkylsilyl group (wherein each alkyl group individually is an alkyl group having 1-12 carbon atom), for example a trimethylsilyl group, triethylsilyl group, tripropylsilyl group, or tributylsilyl group, and r is an integer from 1-10.

Furthermore, other than the above-mentioned compounds, compounds having a polystyrene-reduced number average molecular weight measured by gel permeation chromatography of from 1000 to 5000 can be given as examples of the oxetane compound c). Examples of such compounds are compounds shown by the following formulas (20), (21), and (22): 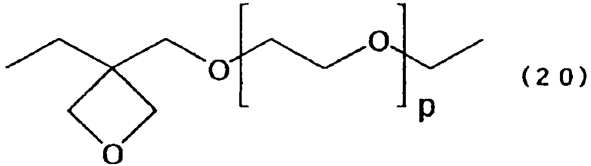 wherein p is an integer from 20-200: 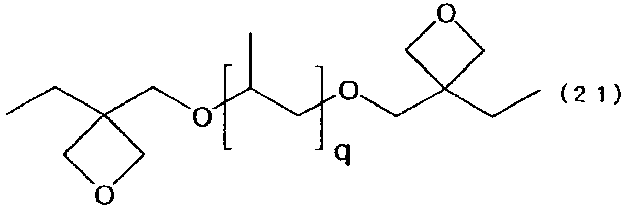 wherein q is an integer from 15-100: 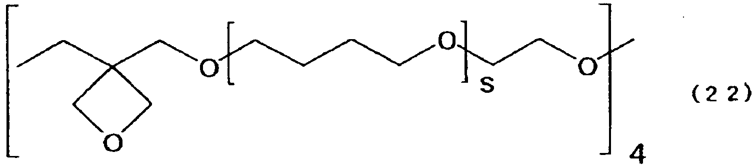 wherein s is an integer from 20-200.

Specific examples of the above-described oxetane compounds are given below:
Compounds containing one oxetane ring in the molecule are:
   3-ethyl-3-hydroxymethyloxetane, 3-(meth)allyloxymethyl-3-ethyloxetane, (3-ethyl-3-oxetanylmethoxy)methylbenzene, (3-ethyl-3-oxetanylmethoxy)benzene, 4-fluoro-[1-(3-ethyl-3-oxetanylmethoxy)methyl]benzene, 4-methoxy-[1-(3-ethyl-3-oxetanylmethoxy)methyl]benzene, [1-(3-ethyl-3-oxetanylmethoxy)ethyl] phenyl ether, isobutoxymethyl (3-ethyl-3-oxetanylmethyl) ether, isobornyloxyethyl (3-ethyl-3-oxetanylmethyl) ether, isobornyl (3-ethyl-3-oxetanylmethyl) ether, 2-ethylhexyl (3-ethyl-3-oxetanyl methyl) ether, ethyldiethylene glycol (3-ethyl-3-oxetanylmethyl) ether, dicyclopentadiene (3-ethyl-3-oxetanylmethyl) ether, dicyclopentenyloxyethyl (3-ethyl-3-oxetanyl methyl) ether, dicyclopentenyl (3-ethyl-3-oxetanylmethyl) ether, tetrahydrofurfuryl (3-ethyl-3-oxetanylmethyl) ether, tetrabromophenyl (3-ethyl-3-oxetanylmethyl) ether, 2-tetrabromophenoxyethyl (3-ethyl-3-oxetanylmethyl) ether, tribromophenyl (3-ethyl-3-oxetanylmethyl) ether, 2-tribromophenoxyethyl (3-ethyl-3-oxetanylmethyl) ether, 2-hydroxyethyl (3-ethyl-3-oxetanyl methyl) ether, 2-hydroxypropyl (3-ethyl-3-oxetanylmethyl) ether, butoxyethyl (3-ethyl-3-oxetanylmethyl) ether, pentachlorophenyl (3-ethyl-3-oxetanylmethyl) ether, pentabromophenyl (3-ethyl-3-oxetanylmethyl) ether, bornyl (3-ethyl-3-oxetanylmethyl) ether.

Compounds containing two or more oxetane rings in the molecule: 3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3-oxetanylmethoxy)methyl]ethane, 1,3-bis[(3-ethyl-3-oxetanylmethoxy)methy]propane, ethylene glycol bis(3-ethyl-3-oxetanylmethyl) ether, dicyclopentenyl bis(3-ethyl-3-oxetanylmethyl) ether, triethylene glycol bis(3-ethyl-3-oxetanylmethyl) ether, tetraethylene glycol bis(3-ethyl-3-oxetanylmethyl) ether, tricyclodecanediyldimethylene (3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipentaerythritol tetrakis(3-ethyl-3-oxetanylmethyl) ether, caprolactone-modified dipentaerythritol hexakis(3-ethyl-3-oxetanylmethyl) ether, caprolactone-modified dipentaerythritol pentakis(3-ethyl-3-oxetanylmethyl) ether, ditrimethylolpropane tetrakis(3-ethyl-3-oxetanylmethyl) ether, EO-modified bisphenol A bis(3-ethyl-3-oxetanylmethyl) ether, PO-modified bisphenol A bis(3-ethyl-3-oxetanylmethyl) ether, EO-modified hydrogenated bisphenol A bis(3-ethyl-3-oxetanylmethyl) ether, PO-modified hydrogenated bisphenol A bis(3-ethyl-3-oxetanylmethyl) ether, EO-modified bisphenol F (3-ethyl-3-oxetanylmethyl) ether. These compounds can be used either individually or in combination of two or more.

Preferred oxetanes are selected from the group consisting of components defined by formula 2, wherein R¹ is a C1-C4 alkyl group, Z = Oxygen and R² = H, a C1-C8 alkyl group or a phenylgroup; 3-ethyl-3-hydroxymethyloxetane, (3-ethyl-3-oxetanylmethoxy)methylbenzene, (3-ethyl-3-oxetanylmethoxy)benzene, 2-ethylhexyl (3-ethyl-3-oxetanyl methyl) ether, 1,4-bis[(3-ethyl-3-oxetanylmethoxy)methyl]benzene, 1,2-bis[(3-ethyl-3-oxetanylmethoxy)methyl] ethane, 1,3-bis[(3-ethyl-3-oxetanylmethoxy)methyl]propane, ethylene glycol bis(3-ethyl-3-oxetanylmethyl) ether and bis(3-ethyl-3-oxetanylmethyl) ether.

The presence of an oxetane in the composition of the instant claimed invention is preferred in order to enhance the faster cure properties.

In one embodiment of the present invention, the preferred oxetane is a monofunctional oxetane having an OH group.

The preferred oxetane is 3-ethyl-3-hydroxymethyl oxetane which is available as Aaron Oxetane OXT-101 from Toagosei Co., Ltd.

In one embodiment the amount of the oxetane is from 0 wt.% to 20 wt.%, relative to the total weight of the composition. In another embodiment the amount of the oxetane is from 5 wt.% to 10 wt.%, relative to the total weight of the composition. In another embodiment the amount of the oxetane is about 8 wt.%.

The composition of the present invention optionally comprises optionally one or more hydroxyl-functional compounds. The hydroxyl-functional compounds may be any organic material having a hydroxyl functionality of at least 1, and preferably at least 2. The material may be liquid or solid that is soluble or dispersible in the remaining components. The material should be substantially free of any groups which inhibit the curing reactions, or which are thermally or photolytically unstable. Preferably, the hydroxyl-functional compounds are either aliphatic hydroxyl functional compounds or aromatic hydroxyl functional compounds.

The aliphatic hydroxyl functional compounds that may be useful for the present compositions include any aliphatic-type compounds that contain one or more reactive hydroxyl groups. Preferably these aliphatic hydroxyl functional compounds are di- or multi-functional compounds (preferably with 2-5 hydroxyl functional groups) such as di- or multi-functional alcohols, polyether-alcohols and polyesters.

Preferably the organic material contains two or more primary or secondary aliphatic hydroxyl groups. The hydroxyl group may be internal in the molecule or terminal. Monomers, oligomers or polymers can be used. The hydroxyl equivalent weight, i.e., the number average molecular weight divided by the number of hydroxyl groups, is preferably in the range of 31 to 5000.

Representative examples of suitable organic materials having a hydroxyl functionality of 1 include alkanols, monoalkyl ethers of polyoxyalkyleneglycols, monoalkyl ethers of alkylene-glycols, and others.

Representative examples of useful monomeric polyhydroxy organic materials include alkylene glycols and polyols, such as 1,2,4-butanetriol; 1,2,6-hexanetriol; 1,2,3-heptanetriol; 2,6-dimethyl-1,2,6-hexanetriol; 1,2,3-hexanetriol; 1,2,3-butanetriol; 3-methyl-1,3,5-pentanetriol; 3,7,11,15-tetramethyl-1,2,3-hexadecanetriol; 2,2,4,4-tetramethyl-1,3-cyclobutanediol; 1,3-cyclopentanediol; trans-1,2-cyclooctanediol; 1,16-hexadecanediol; 1,3-propanediol; 1,4-butanediol; 1,5-pentanediol; 1,6-hexanediol; 1,7-heptanediol; 1,8-octanediol; 1,9-nonanediol.

Representative examples of useful oligomeric and polymeric hydroxyl-containing materials include polyoxyethylene and polyoxypropylene glycols and triols of molecular weights from 200 to 10000; polytetramethylene glycols of varying molecular weight; copolymers containing pendant hydroxyl groups formed by hydrolysis or partial hydrolysis of vinyl acetate copolymers, polyvinylacetal resins containing pendant hydroxyl groups; hydroxyl-terminated polyesters and hydroxyl-terminated polylactones; hydroxyl-functionalized and polyalkadienes, such as polybutadiene; and hydroxyl-terminated polyethers.

Other hydroxyl-containing monomers are 1,4-cyclohexanedimethanol and aliphatic and cycloaliphatic monohydroxy alkanols.

Other hydroxyl-containing oligomers and polymers include hydroxyl and hydroxyl/epoxy functionalized polybutadiene, polycaprolactone diols and triols, ethylene/butylenes polyols, and combinations thereof. Examples of polyether polyols are also polypropylene glycols of various molecular weights and glycerol propoxylate-B-ethoxylate triol, as well as linear and branched polytetrahydrofuran polyether polyols available in various molecular weights, such as for example 250, 650, 1000, 2000, and 2900 MW.

Preferred hydroxyl functional compounds are for instance simple di- or multi-functional alcohols, polyether-alcohols, and/or polyesters. Suitable examples of di- or multi-functional alcohols are, trimethylolpropane, trimethylolethane, pentaeritritol, di-pentaeritritol, glycerol, 1,4-hexanediol, and 1,4-hexanedimethanol.

Suitable polyethers include, for example, alkoxylated trimethylolpropane, or ethoxylated or propoxylated polyether compounds, polyethyleneglycol-200 or -600. In one embodiment of the instant claimed invention the polyether used is Pluracol GP 430, a glycerine propoxylated polyether triol with an average molecular weight of about 400 and available from BASF.

Suitable polyesters include hydroxyfunctional polyesters from diacids and diols with optionally small amounts of higher functional acids or alcohols. Suitable diols are those described above. Suitable diacids are, for example, adipic acid, dimer acid, hexahydrophthalic acid, and 1,4-cyclohexane dicarboxylic acid. Other suitable ester compounds include caprolactone based oligo- and polyesters such as the trimethylolpropane-triester with caprolactone, Tone.RTM.0301 and Tone.RTM.0310 (Dow Chemical Company). The ester based polyols preferably have a hydroxyl number higher than 50, in particular higher than 100. The acid number preferably is lower than 10, in particular lower than 5. Preferred polyester polyols include Desmophen 850, which is a linear polyester polyol available from Bayer. Another preferred aromatic hydroxyl-functional compound is a difunctional polyester polyol such as Lupraphen 8004 which is available from BASF.

One of preferred aliphatic hydroxyl-functional compounds is trimethylolpropane, which is commercially available.

Aromatic hydroxyl functional compounds that may be useful for the present compositions include aromatic-type compounds that contain one or more reactive hydroxyl groups. Preferably, these aromatic hydroxyl functional compounds would include phenolic compounds having at least 2 hydroxyl groups as well as phenolic compounds having at least 2 hydroxyl groups which are reacted with ethylene oxide, propylene oxide or a combination of ethylene oxide and propylene oxide.

The most preferred aromatic functional compounds include bisphenol A, bisphenol S, ethoxylated bisphenol A, ethoxylated bisphenol S.

These hydroxyl functional compounds are preferably present from 3% to 20% by weight, more preferably, from 5% to 18% by weight, of the total liquid radiation-cured composition.

In one embodiment of the instant claimed invention the hydroxyl functional compound is a polyol. In another embodiment of this invention the hydroxyl functional compound is a polyol which is a polyether triol. As previously mentioned, in one embodiment of the instant claimed invention the polyether used is Pluracol GP 430, which is a glycerine propoxylated polyether triol with an average molecular weight of about 400 and available from BASF.

When the hydroxyl functional compound is a polyol, in one embodiment the amount of the polyol is from 1 wt.% to 20 wt.%, relative to the total weight of the composition. In another embodiment the amount of the polyol is from 5 wt.% to 15 wt.%, relative to the total weight of the composition. In another embodiment the amount of the polyol is about 12 wt. %.

The composition of the present invention Optionally comprises additives selected from the group consisting of light stabilizer/UV absorbers; antioxidants; acid stabilizers; wetting agents and air release agents.

Light Stabilizer/UV Absorbers are well known in the art of stereolithography technology. Suitable Light Stabilizer/UV Absorbers are well known to people of ordinary skill in the art of liquid radiation curable resins. Suitable light stabilizer/UV absorbers include hindered amine light stabilizers (HALS), HALS stabilizers with phenolic antioxidant moiety, HALS stabilizers with aminoether functionality, hydroxyphenylbenzotriazole UV absorbers, hydroxyphenyl-triazine (HPT) UV absorbers, oxanilide UV absorbers. They are commercially available under the trade name "Tinuvin" series products from Ciba Specialty Chemicals.

In one embodiment the amount of the Light Stabilizer/UV Absorbers is from 0.01 wt.% to 1 wt.%, relative to the total weight of the composition. In another embodiment the amount of the Light Stabilizer/UV Absorbers is from 0.1 wt.% to 1 wt.%, relative to the total weight of the composition. In another embodiment the amount of the Light Stabilizer/UV Absorbers is about 0.3 wt. %.

Antioxidants are well known in the art of stereolithography technology. Suitable antioxidants are well known to people of ordinary skill in the art of liquid radiation curable resins. Suitable antioxidants include hindered phenols (available as Irganox series products from Ciba) and phosphites (available as Irgafos series products from Ciba). In one embodiment of the instant claimed invention the suitable antioxidant is either sterically hindered phenol propionate (Irganox 1010, available from Ciba) or a sulfur containing primary phenolic propionate (Irganox 1035 also available from Ciba).

In one embodiment, the preferred antioxidant is Irganox 1035 which is available from Ciba.

In one embodiment the amount of the antioxidant is from 0 wt.% to 1 wt.%, relative to the total weight of the composition. In another embodiment the amount of the antioxidant is from 0.1 wt.% to 0.5 wt.%, relative to the total weight of the composition. In another embodiment the amount of the antioxidant is about 0.2 wt. %.

Acid Stabilizers are well known in the art of stereolithography technology. Suitable Acid Stabilizers are well known to people of ordinary skill in the art of liquid radiation curable resins. Suitable acid stabilizers include polyvinylpyrrolidone and rubidium carbonate. Polyvinylpyrrolidone (PVP) is known to be polar and because of its polarity it may flocculate pigments. Therefore, the use of polyvinylpyrrolidone must be carefully evaluated with each selected color masking agent.

In one embodiment the amount of the Acid Stabilizer is from 0.0 wt.% to 0.1 wt.%, relative to the total weight of the composition. In another embodiment the amount of the Acid Stabilizer is from 0.0 wt.% to 0.01 wt.%, relative to the total weight of the composition. In another embodiment the amount of the Acid Stabilizer is about 0.005 wt.%.

Wetting Agents are well known in the art of stereolithography technology. In one embodiment the suitable wetting agent is Silwet L-7600 which is available from Momentive.

In one embodiment the amount of the wetting agents is from 0 wt.% to 1 wt.%, relative to the total weight of the composition. In another embodiment the amount of the wetting agents is from 0.1 wt.% to 0.5 wt.%, relative to the total weight of the composition. In another embodiment the amount of the wetting agents is about 0.2 wt.%.

Air release agents are well known in the art of stereolithography technology. Suitable air release agents include the following: silicone free solution containing naphtha and other components. In one embodiment, the preferred air release agent is BYK A501, which is available form BYK-Chemie.

In one embodiment the amount of the air release agent is from 0 wt.% to 0.5wt.%, relative to the total weight of the composition. In another embodiment the amount of the air release agent is from 0.01 wt.% to 0.05 wt.%, relative to the total weight of the composition. In another embodiment the amount of the air release agent is about 0.02 wt. %.

The compositions of the instant claimed invention comprise a color masking agent selected from the group consisting of blue, violet, red, yellow, organs and green pigments. Pigments are well known in the art of stereolithography technology. General descriptions of pigments can be found in the reference, "The Printing Ink Manual", Fifth Edition, Edited by R.H. Leach and R. J. Pierce and E.P. Hickman, MJ. Mackenzie and H.G. Smith; © 1993 by Society of British Printing Ink, pgs. 140-187.

Suitable blue pigments include Phthalocyanine Blue, Alkali Blue, Ultramarine Blue, Indanthrene Blue and Benzimidazolone Dioxazine Blue. Suitable violet pigments include Carbazole Violet, Dioxazine Violet (RL), Dioxazine Violet B, Quinacridone Violet and Perylene Violet. Such pigments are commercially available from The Flint Group, Clariant, Ciba and BASF.

Suitable Red pigments are Napthol Red and Carmine F.B.

Suitable Yellow pigments are Diazo Yellow GRX and Isoindoline Yellow.

Suitable Orange pigments are Permanent Orange G and Fast Orange F2G.

A suitable Green pigment is Pthalocyanine Green.

In practice, even though all pigments themselves are dry, it is typical and preferred to disperse dry pigments in a low viscosity chemical component of the composition of the instant claimed invention. Such dispersions are typically made by milling a known amount of a dry pigment in the low viscosity component or carrier in presence of dispersants, stabilizer, etc.

Commercially available pigment dispersions are available; however some users of pigments typically make dispersions in-house to achieve compatibility with their final products. The typical solids level in the commercially available pigment dispersions as received is about 20 wt.%. This 20 wt.% solids pigment dispersions are typically diluted further so that there final weight percent solids is between 0.2 and 0.3 wt.% as added to the liquid resin composition.

Commercially available pigment dispersions are available from Perm Color Inc. and Sun Chemical and other companies.

In one embodiment of the instant claimed invention where the color masking agent comprises a blue pigment, the preferred blue pigment dispersion is Phthalocyanine Blue PRINT Blue 15DT7083 Spec, available from the Flint Group Pigments.

In one embodiment where a blue pigment dispersion is used either by itself as a Color Masking Agent or in combination with other pigments as a Color Masking Agent, the amount of the blue pigment dispersion is from 0.1 ppm to 5 ppm, relative to the total weight of the composition. In another embodiment the amount of the blue pigment dispersion is from 1 ppm to 3 ppm, relative to the total weight of the composition. In another embodiment the amount of the blue pigment dispersion is about 2 ppm.

In one embodiment of the instant claimed invention where the color masking agent comprises a violet pigment, the preferred violet pigment dispersion is Carbazole Violet Hostaperm Violet RL, Pigment Violet 23, Spec, available from Clariant.

In one embodiment where a violet pigment dispersion is used either by itself as a Color Masking Agent or in combination with other pigments as a Color Masking Agent, the amount of the violet pigment dispersion is from 0.1 ppm to 5 ppm, relative to the total weight of the composition. In another embodiment the amount of the violet pigment dispersion is from 1 ppm to 4 ppm, relative to the total weight of the composition. In another embodiment the amount of the violet pigment dispersion is about 3 ppm.

Persons of ordinary skill in the art know about commercially available dyes that can be used in formulating liquid radiation curable compositions. It is known that dyes may be affected by cationic acid generated by the actions of the cationic photoinitiator. Therefore, it is recommended to use pigments, rather than dyes, as color masking agents for formulations when cationic photoinitiators are present. It is understood that dyes are useful as color masking agents for all acrylated formulations

The composition of the present invention always comprises a free radical photoinitiator as acrylates require a free radical photoinitiator.

Examples of suitable free radical photoinitiators include benzoins, such as benzoin, benzoin ethers, such as benzoin methyl ether, benzoin ethyl ether, and benzoin isopropyl ether, benzoin phenyl ether, and benzoin acetate, acetophenones, such as acetophenone, 2,2-dimethoxyacetophenone, 4-(phenylthio)acetophenone, and 1,1-dichloroacetophenone, benzil, benzil ketals, such as benzil dimethyl ketal, and benzil diethyl ketal, anthraquinones, such as 2-methylanthraquinone, 2-ethylanthraquinone, 2-tertbutylanthraquinone, 1-chloroanthraquinone, and 2-amylanthraquinone, also triphenylphosphine, benzoylphosphine oxides, such as, for example, 2,4,6-trimethylbenzoyldiphenylphosphine oxide (Lucirin TPO), benzophenones, such as benzophenone, dimethoxybenzophenone, diphenoxybenzophenone, and 4,4'-bis(N,N'-dimethylamino)benzophenone, thioxanthones and xanthones, acridine derivatives, phenazene derivatives, quinoxaline derivatives or 1-phenyl-1,2-propanedione-2-O-benzoyloxime, 1-aminophenyl ketones or 1-hydroxyphenyl ketones, such as 1-hydroxycyclohexyl phenyl ketone, phenyl (1-hydroxyisopropyl)ketone and 4-isopropylphenyl(1-hydroxyisopropyl)ketone, or triazine compounds, for example, 4"'-methyl thiophenyl-1-di(trichloromethyl)-3,5-S-triazine, S-triazine-2-(stilbene)-4,6-bistrichloromethyl, and paramethoxy styryl triazine, all of which are known compounds.

Suitable free-radical photoinitiators, which are normally used in combination with a He/Cd laser, operating at for example 325 nm, an Argon-ion laser, operating at for example 351 nm, or 351 and 364 nm, or 333, 351, and 364 nm, or a frequency tripled YAG solid state laser, having an output of 351 or 355 nm, as the radiation source, are acetophenones, such as 2,2-dialkoxybenzophenones and 1-hydroxyphenyl ketones, for example 1-hydroxycyclohexyl phenyl ketone, 2-hydroxy-1-{4-(2-hydroxyethoxy)phenyl}-2-methyl-1-propanone, benzophenone, or 2-hydroxyisopropyl phenyl ketone (also called 2-hydroxy-2,2-dimethylacetophenone), but especially 1-hydroxycyclohexyl phenyl ketone. Another class of free-radical photoinitiators comprises the benzil ketals, such as, for example, benzil dimethyl ketal. Especially an alpha-hydroxyphenyl ketone, benzil dimethyl ketal, or 2,4,6-trimethylbenzoyldiphenylphosphine oxide may be used as photoinitiator.

In one embodiment of the instant claimed invention suitable free radical photoinitiators include benzil dimethyl ketal, 1-hydroxycyclohexyl phenyl ketone, 2-hydroxy-2-methyl-1-phenylpropan-1-one, 2,2-dimethoxyacetophenone, benzophenone and 2,4,6-trimethylbenzoyldiphenylphosphine oxide. These photoinitiators alone or in combination with each other tend to be comparatively less yellowing.

In one embodiment of the instant claimed invention, when the present composition comprises acrylates, with no cationic curable components present, the present composition comprises, relative to the total weight of the composition, from 0.5 wt.% to 5 wt.% of one or more free radical photoinitiators. In one embodiment, the present composition comprises, relative to the total weight of the composition, from 1 wt.% to 4 wt.% of one or more free radical photoinitiators, relative to the total weight of the composition. In another embodiment, the present composition comprises, relative to the total weight of the composition, from 2 wt.% to 4 wt.% of one or more free radical photoinitiators.

In one embodiment of the instant claimed invention, when the present composition comprises acrylates and at least one cationic curable component present, the present composition comprises, relative to the total weight of the composition, from 0.5 wt.% to 5 wt.% of one or more free radical photoinitiators. In one embodiment, the present composition comprises, relative to the total weight of the composition, from 1 wt.% to 4 wt.% of one or more free radical photoinitiators, relative to the total weight of the composition. In another embodiment, the present composition comprises, relative to the total weight of the composition, from 2 wt.% to 4 wt.% of one or more free radical photoinitiators.

When cationic curable components are present, the composition of the present invention comprises a cationic photoinitiator. In the compositions according to the invention, any suitable type of photoinitiator that, upon exposure to actinic radiation, forms cations that initiate the reactions of the cationically polymerizable compounds, such as epoxy material(s), can be used.

There are a large number of known and technically proven cationic photoinitiators that are suitable. They include, for example, onium salts with anions of weak nucleophilicity. Examples are halonium salts, iodosyl salts or sulfonium salts, such as are described in published European patent application EP 153904 and WO 98/28663, sulfoxonium salts, such as described, for example, in published European patent applications EP 35969, 44274, 54509, and 164314, or diazonium salts, such as described, for example, in U.S. Patents 3,708,296 and 5,002,856. Other cationic photoinitiators are metallocene salts, such as described, for example, in published European applications EP 94914 and EP 94915.

Preferred photoinitiators include diaryl iodonium salts, or triaryl sulfonium salts. Typical photo-polymerization photoinitiators are represented by the following formulae (24) and (25): 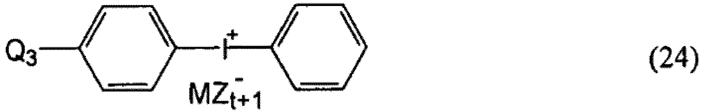 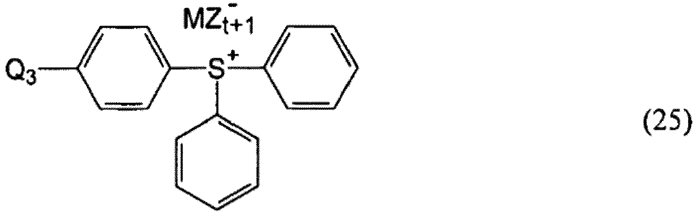 wherein
Q₃ represents a hydrogen atom, an alkyl group having 1 to 18 carbon atoms, or an alkoxyl group having 1 to 18 carbon atoms;
M represents a metal atom, preferably antimony;
Z represents a halogen atom, preferably fluorine; and
t is the valent number of the metal, for example 6 in the case of antimony.

Preferred cationic photoinitiators include sulfonium antimonate salts, which are commercially available.

The present composition comprises, relative to the total weight of the composition, from 1 wt.% to 5 wt.% of one or more cationic photoinitiators. In one embodiment, the present composition comprises, relative to the total weight of the composition, from 2 wt.% to 4 wt.% of one or more cationic photoinitiators, relative to the total weight of the composition. In another embodiment, the present composition comprises, relative to the total weight of the composition, from 3 wt.% to 4 wt.% of one or more cationic photoinitiators.

| The preferred composition of the second aspect of the instant claimed invention has the following components: | | | |
|---|---|---|---|
| Chemical Type | Component | Weight (%) | |
| | | | |
| Cycloaliphatic epoxy | Celloxide 2021P | 44.5800 | |
| Hydrogenated Bisphenol A diglycidylether | | | |
| | Eponex 1510 | 10.0000 | |
| Oxetane | OXT-101 | 8.0000 | |
| Propoxylated trimethylol propane triacrylate | | | |
| | SR492 | 11.9995 | |
| Bisphenol A diglycidylether diacrylate | | | |
| | Ebecryl 3700 | 6.0000 | |
| Polyether polyol | Pluracol GP430 | 12.0000 | |
| Free radical photoinitiator | Irgacure 184 | 3.0000 | |
| Cationic photoinitiator | Chivacure 1176 | 4.0000 | |
| Antioxidant, additive | Irganox 1035 | 0.2000 | |
| Wetting agent, additive | Silwet L-7600 | 0.2000 | |
| Air release agent, additive | BYK A501 | 0.0200 | |
| Blue pigment dispersion | Phthalocyanine Blue | 0.0002 | |
| Violet pigment dispersion | Carbazole Violet | 0.0003 | |
| | Total | 100.0000 | |

The second aspect of the instant claimed invention is a liquid radiation curable resin comprising:
a) an acrylate component, wherein the acrylate component is selected from the group consisting of one or more mono, di- or multi-functional acrylates and one or more urethane acrylate oligomers;
b) optionally, one or more vinyl compounds;
c) optionally one or more hydroxyl-Functional Compounds;
d) optionally, one or more additives selected from the group consisting of
   i) light stabilizer/UV absorbers;
   ii) antioxidants;
   iii) wetting agents;
   iv) air release agents;
e) a free radical photoinitiator; and
f) a color masking agent selected from the group consisting of blue, violet, red, yellow, orange and green pigments;
   wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The resin composition of the present invention comprises an acrylate component, wherein the acrylate component is selected from the group consisting of one or more mono, di- or multi-functional acrylates and one or more urethane acrylate oligomers

Examples of suitable monocrylates are isobornyl acrylate (EBOA), phenoxyethyl acrylate, isodecyl acrylate, hexyl acrylate, cyclohexyl acrylate, 2-ethylhexyl acrylate, octyl acrylate, nonyl acrylate, stearyl acrylate, 2-phenoxy acrylate, 2-methoxyethyl acrylate, lactone modified esters of acrylic and methacrylic acid, methyl methacrylate, butyl acrylate, isobutyl acrylate, methacrylamide, allyl acrylate, tetrahydrofuryl acrylate, n-hexyl methacrylate, 2-(2-ethoxy-ethoxy)ethyl acrylate, n-lauryl acrylate, 2-phenoxyethyl acrylate, glycidyl, methacrylate, glycidyl acrylate, acrylated methylolmelamine, and 2-(N,N-diethylamino)-ethyl acrylate. A preferred example is a fully saturated bicyclic acrylate such as, for example, isobornyl acrylate.

In one embodiment of the acrylate only composition, the composition comprises from 15 wt.% to 60 wt.% of the monocrylates, relative to the total weight of the composition. In another embodiment, the composition comprises from 25 wt.% to 50 wt.% of the monoacrylates, relative to the total weight of the composition. In another embodiment the composition comprises about 41 wt.% of the monoacrylates.

Examples of suitable diacrylates include neopentyl glycol diacrylate, alkoxylated neopentyl glycol diacrylate, ethylene glycol diacrylate, hexylene glycol diacrylate, diethylene glycol diacrylate, tripropylene glycol diacrylate, tetraethylene glycol diacrylate.

Examples of suitable aliphatic diacrylates are cycolhexane dimethanol di(meth)acrylate, alkoxylated hexanediol diacrylate, alkoxylated cyclohexane dimethanol di(meth)acrylate, neopentyl glycol di(meth)acrylate, alkoxylated neopentyl glycol diacrylate, 1,6 hexanediol di(meth)acrylate, tripropylene glycol diacrylate, polyethylene glycol di(meth)acrylate, propoxylated neopentyl glycol diacrylate.

In one embodiment of the acrylate only composition, the composition comprises from 15 wt.% to 65wt.% of the aliphatic diacrylates, relative to the total weight of the composition. In another embodiment, the composition comprises from 25wt.% to 50wt.% of the aliphatic diacrylates, relative to the total weight of the composition. In another embodiment the composition comprises about 47 wt.% of the aliphatic diacrylates.

Examples of suitable aromatic diacrylates are bisphenol A di(meth)acrylate, bisphenol F di(meth)acrylate, bisphenol S di(meth)acrylate, EO-modified bisphenol A di(meth)acrylate, PO-modified bisphenol A di(meth)acrylate, EO-modified bisphenol F di(meth)acrylate, PO-modified bisphenol F di(meth)acrylate, EO-modified bisphenol S di(meth)acrylate, PO-modified bisphenol S di(meth)acrylate.

In an embodiment, the preferred aromatic diacrylate is bisphenol A diglycidylether diacrylate.

In one embodiment of the acrylate only composition, the composition comprises from 15 wt.% to 60 wt.% of the aromatic diacrylates, relative to the total weight of the composition. In another embodiment, the composition comprises from 20 wt.% to 50 wt.% of the aromatic diacrylates, relative to the total weight of the composition. In another embodiment the composition comprises about 41 wt.% of the aromatic diacrylates.

Examples of multi- functional acrylates include pentaerythritol di-, tri-, terra-, or penta-acrylate, trimethylolpropane triacylate, alkoxylated trimethylolpropane triacrylate which contains from 2 to 14 moles of either ethylene or propylene oxide, triethylene glycol diacrylate, tetraethylene glycol diacrylate, polyethylene glycol diacrylate, any corresponding methacrylates thereof, and combinations thereof.

In one embodiment of the instant claimed invention, when the present composition comprises acrylates, with no cationic curable components present, the present composition comprises, relative to the total weight of the composition, from 0.5 wt.% to 5 wt.% of one or more free radical photoinitiators. In one embodiment, the present composition comprises, relative to the total weight of the composition, from 1 wt.% to 4 wt.% of one or more free radical photoinitiators, relative to the total weight of the composition. In another embodiment, the present composition comprises, relative to the total weight of the composition, from 2 wt.% to 4 wt.% of one or more free radical photoinitiators.

The urethane acrylate oligomers can be any of the conventional acrylourethanes prepared by reacting an olefinically unsaturated compound with an isocyanate-functional urethane formed by the reaction of an excess of a polyisocyanate with a polyol selected from the group consisting of polyether, polycarbonate, polyolefm, polyester, polycaprolactone and polyetherester polyols. These urethane acrylate oligomers may be obtained using synthesis techniques known in the art of radiation curable compositions or they may be purchased commercially. In one embodiment of the instant claimed invention the urethane acrylate oligomer is an aliphatic urethane diacrylate oligomer available from Bomar or Sartomer.

The composition of the third aspect of the instant claimed invention optionally comprises a vinyl compound. Suitable vinyl compounds include this type of linkage: N-vinyl, vinyl-ether, vinylester or allyl. Suitable examples of vinyl compounds include N-vinylformamide (NVF), adducts of NVF with diisocyanates such as toluene diisocyanate and isophorone diisocyanate, derivatives of N-vinylformamide, N-vinylcaprolactam, N-vinylpyrrolidone, butyl-vinylether, 1,4-butyl-divinylether, dipropyleneglycol-divinylether, the vinylester of acetic acid, lauryl acid, dodecanoic acid or cyclohexylcarboxylic acid, adipic acid, or glutaric acid, triallylisocyanurate, diallylphthalate, and butyl-allyl-ether.

In one aspect of the instant claimed invention suitable vinyl compounds include N-vinyl pyrrolidone, N-vinyl caprolactam, and N-vinyl formamide. In another aspect of the instant claimed invention, N-vinyl caprolactam is the vinyl compound used.

The remaining individual elements of the second aspect of the instant claimed invention described above are the same as those individual elements of the invention which have been previously described. As such, a description of such individual elements will not be repeated here.

The following is an example of an acrylate-vinyl amide formula.

| Chemical Type | Component | Wt % |
|---|---|---|
| Aliphatic urethane diacrylate oligomer | BR 543 | 35.50 |
| Polyethylene Glycol (400) Diacrylate (MW 508) | SR 344 | 12.00 |
| (Ethoxylated)₄ Nonylphenol Acrylate (450 MW) | SR 504D | 15.00 |
| Vinyl amide | Vinyl Caprolactam | 8.00 |
| Cyclic Trimethylolpropane Formal Acrylate (200 MW) | SR 531 | 18.00 |
| Isodecyl Acrylate (192 MW) | SR 395 | 8.00 |
| Hindered phenol antioxidant | Irganox 1035 | 0.50 |
| alpha,alpha-dimethoxv-alpha-phenvlacetophenone free radical initiator | Irgacure 651 | 3.00 |
| Blue pigment dispersion | Phthalocyanine Blue | 0.0002 |
| Violet pigment dispersion | Carbozole Violet | 0.0003 |
| | Total | 100.00 |

A third aspect of the instant claimed invention is a clear and colorless, three-dimensional article made from a liquid radiation curable resin comprising:
a) one or more di- or multi-functional acrylates;
b) one or more epoxy compounds, wherein at least one of said epoxy compounds is selected from the group consisting of cycloaliphatic epoxy compounds, hydrogenated bisphenol A diglycidylether and mixtures thereof;
c) optionally, an oxetane;
d) optionally one or more hydroxyl-functional compounds;
e) optionally, one or more additives selected from the group consisting of
   i) light stabilizer/UV absorbers;
   ii) antioxidants;
   iii) acid stabilizers;
   iv) wetting agents;
   v) air release agents;
f) a free radical photoinitiator;
g) a cationic photoinitiator; and
i) a color masking agent selected from the group consisting of blue, violet, red, yellow, orange and green pigments;
   wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CEELAB color space using a spectrophotometer in the visible wavelengths of 400-750 nm.

The individual elements of the third aspect of the instant claimed invention described above are the same as those individual elements of the invention which have been previously described. As such, a description of such individual elements will not be repeated here.

A fourth aspect of the instant claimed invention is a clear and colorless, three-dimensional article made from a liquid radiation curable resin comprising:
a) an acrylate component, wherein the acrylate component is selected from the group consisting of one or more mono, di- or multi-functional acrylates and one or more urethane acrylate oligomers;
b) optionally one or more vinyl compounds;
c) optionally one or more hydroxyl-functional compounds;
d) optionally, one or more additives selected from the group consisting of
   i) light stabilizer/UV absorbers;
   ii) antioxidants;
   iii) wetting agents;
   iv) air release agents;
e) a free radical photoinitiator; and
f) a color masking agent selected from the group consisting of blue, violet, red, yellow, orange and green pigments;
   wherein said liquid radiation curable resin, when cured as described herein, has the following properties
   i) a clarity and transmittance of greater than 67% as measured by UV-Visible spectrophotometer in the 400-500 nm range; and
   ii) a lack of color as measured by a b* value of between minus 0.5 and positive 2.5 in the CIELAB color space using a spectrophotometer in the visible wavelengths of 400-750 nm.

The individual elements of the embodiments of this invention described above are the same as those individual elements of the invention which have been previously described. As such, a description of such individual elements will not be repeated here.

In known stereolithography techniques the desired shaped article is built up from a radiation-curable composition with the aid of a recurring, alternating sequence of two steps (a) and (b). In step (a), a layer of the radiation-curable composition, one boundary of which is the surface of the composition, is cured with the aid of appropriate imaging radiation, preferably imaging radiation from a computer-controlled scanning laser beam, within a surface region which corresponds to the desired cross-sectional area of the shaped article to be formed, and in step (b) the cured layer is covered with a new layer of the radiation-curable composition, and the sequence of steps (a) and (b) is repeated until a so-called green model of the desired shape is finished. This green model is, in general, not yet fully cured and may therefore be subjected to post-curing, though such post curing is not required.

Commercially available stereolithography equipment to create three-dimensional shaped articles is well known and is available from 3D SYSTEMS CORPORATION, a Delaware corporation having its principal place of business at 333 Three D Systems Circle, Rock Hill, SC 29730, among others.

The individual elements of the embodiments of this invention described above are the same as those individual elements of the invention which have been previously described. As such, a description of such individual elements will not be repeated here.

The specific examples herein disclosed are to be considered as being primarily illustrative. Various changes beyond those described, will, no doubt, occur to those skilled in the art; and such changes are to be understood as forming a part of this invention.

### EXAMPLES

The present invention is further illustrated with a number of examples, which should not be regarded as limiting the scope of the present invention. The components listed in these Examples have the following commercial names, are available from the listed source and have the indicated chemical composition.

| Commercial Name | Supplier | Description |
|---|---|---|
| Ebecryl 3700 | Cytec | Bisphenol A diglycidylether diacrylate |
| Celloxide 2021P | Daicel Chemical | Cycloaliphatic epoxy |
| Eponex 1510 | Hexion | Hydrogenated bisphenol A diglycidylether |
| OXT-101 | Toagosei | 3-ethyl-3-hydroxymethyl-oxetane |
| SR 492 | Sartomer | Propoxylated trimethylolpropane triacrylate |
| Pluracol GP430 | BASF | Propoxylated glycerol (polyether triol) |
| Silwet L-7600 | Momentive | Polyalkyleneoxide modified polydimethylsiloxane |
| BYK-A-501 | BYK-Chemie | silicone-free solution of foam destroying polymers |
| Irganox 1035 | Ciba | Hindered phenol antioxidant |
| PRINT Blue 15DT7083 | The Flint Group | Phthalocyanine Blue pigment |
| Hostaperm Violet RL, Pigment Violet 23 | Clariant | Carbozole Violet pigment |
| IRGACURE 184 | Ciba | 1-hydroxycyclohexyl phenyl ketone, free radical photoinitiator |
| Chivacure-1176 | Chitec | mixture of triarylsulfonium hexafluoroantimonate salts, cationic photoinitiator |
| BR-543 | Bomar Specialties | Aliphatic urethane diacrylate oligomer |
| SR 344 | Sartomer | Polyethylene glycol (400) diacrylate (MW 508) |
| SR 504D | Sartomer | Ethoxylated(4) Nonylphenol acrylate (MW 450) |
| SR 531 | Sartomer | Cyclic trimethylolpropane formal acrylate (MW 200) |
| SR 395 | Sartomer | Isodecyl acrylate (MW 192) |
| Irgacure 651 | Ciba | α, α-dimethoxy-alpha-phenylacetophenone free radical photoinitiator |
| Vinyl Caprolactam | BASF | Vinyl amide |

### Example 1

The following radiation curable liquid resin was made. The radiation curable liquid composition was prepared by weighing all the components into a container under mechanical stirring either at room temperature or up to 50 °C until a homogeneous resin mixture was obtained. The liquid mixture was then filtered off into a vat of stereolithography apparatus using a medium paint filter before fabrication of parts.

| Chemical Type | Component | Weight (%) | |
|---|---|---|---|
| | | | |
| Cycloaliphatic epoxy | Celloxide 2021P | 44.5800 | |
| Hydrogenated Bisphenol A diglycidylether | | | |
| | Eponex 1510 | 10.0000 | |
| Oxetane | OXT-101 | 8.0000 | |
| Propoxylated TMPTA | SR492 | 11.9995 | |
| Bisphenol A diglycidylether diacrylate | | | |
| | Ebecryl 3700 | 6.0000 | |
| Polyether polyol | Pluracol GP430 | 12.0000 | |
| Free radical photoinitiator | Irgacure 184 | 3.0000 | |
| Cationic photoinitiator | Chivacure 1176 | 4.0000 | |
| Antioxidant, additive | Irganox 1035 | 0.2000 | |
| Wetting agent, additive | Silwet L-7600 | 0.2000 | |
| Air release agent, additive | BYK A501 | 0.0200 | |
| Blue pigment dispersion | Phthalocyanine Blue | 0.0002 | |
| Violet pigment dispersion | Carbozole Violet | 0.0003 | |
| | Total | 100.0000 | |

### Comparative Example 2A and Example of the Invention 2B

### All Acrylate formulation:

The following radiation curable liquid resins were made with and without color masking agents. Each radiation curable liquid composition was prepared by weighing all the components into a container under mechanical stirring either at room temperature or up to about 50 °C until homogeneous resin mixtures were obtained. Each liquid mixture was then filtered off into a vat of stereolithography apparatus using a medium paint filter before fabrication of parts.

The second column in the table below (Comparative Example 2A, not an Example of the instant claimed invention)- shows that without color masking agents the appearance, to the human eye, of the cured articles made using the liquid radiation curable resin is Light Yellow.

After the formulation was remade, see the third column in the table below (this is Example 2B, which is an Example of the instant claimed invention), including color masking agents (a blue pigment dispersion and a violet pigment dispersion) and articles were made by curing this remade formulation, the visual appearance of the cured article was colorless.

| | **Comparative Example 2A** | **Example 2B** |
|---|---|---|
| Component | Wt% | Wt% |
| BR 543 | 35.00 | 35.50 |
| SR 344 | 12.00 | 12.00 |
| SR 504D | 15.00 | 15.00 |
| Vinyl Caprolactam | 8.00 | 8.00 |
| SR 531 | 18.00 | 18.00 |
| SR 395 | 8.50 | 8.00 |
| Irganox 1035 | 0.50 | 0.50 |
| Irgacure 651 | 3.00 | 3.00 |
| Blue pigment dispersion | 0.00 | 0.0002 |
| Violet pigment dispersion | 0.00 | 0.0003 |
| | 100 | 100.00 |
| | | |
| Visual Color (eye) | Light yellow | Colorless |

### COMPARATIVE Example 3

A commercial product, Accura® 60 from 3D systems was obtained. Three-dimensional articles were made using this liquid radiation curable resin by using stereolithographic equipment.

The Accura® 60 liquid radiation curable resin was poured into a vat of a stereolithography apparatus in order to fabricate parts.

### Parts built using laboratory grade stereolithography equipment:

Two laboratory units are not commercially available machines. They are primarily used for R&D activities.

A suite of parts of varying thickness and geometry were built using the layer-by-layer additive process of stereolithography by consecutively imaging 150 micrometers (6 mils) thick layers of the composition to be tested. Each cross-sectional layer of the parts was given UV exposure sufficient to polymerize the composition at a 250 micrometers depth, providing approximately 100 micrometers of overcure or engagement cure to ensure adhesion to the previously coated and exposed layer. The layers were exposed with a laser, a frequency tripled YAG (solid state) laser, emitting at 354.7 nm in the UV region and pulsing at 80 kHz. During the build the temperature and relative humidity in the machine chamber were approx. 30°C and 30%. When the parts were built, they were removed from the stereolithography machine, washed with tri(propyleneglycol)methyl ether ("TPM") and isopropanol, dried in laboratory hood and then placed in a commercially available UV postcuring apparatus ("PCA" sold by 3D Systems). The PCA apparatus uses 14 tubular florescent lamps; seven of them are TLK40W/3 type emitting UV radiation in 400-440 nm range and other seven are TLK40W/5 type emitting in 300-460 nm. The parts were subjected to approximately 30-60 minutes of UV radiation at room temperature in the PCA.

### Parts built using commercial stereolithography machines:

Stereolithography machines sold by 3D Systems, namely SLA 7000, Viper Si and SLA 250, were also used to build parts. All of these machines were equipped with solid state lasers emitting at 354.7 nm. The differences in laser power, beam diameter, vat size, control software, etc. between these machines are well-known in the art of stereolithography. The key parameters used in parts building were critical exposure (E_{c}, mJ/cm²), depth of penetration (Dₚ, mils) and hatch over cure (HOC, mils) measured for a specific composition. Other parameters which may be varied were border over cure, number of up fills and down fills, recoating speed, delays/wait periods (during or after recoating, after platform is dipped, after a layer is scanned) etc. The significance of these parameters and their role in stereolithography process are well-known in the art. The typical layer thickness during build was 0.2 mm (6 mils). Temperature and relative humidity during build were approximately 30 °C and 30 %.

When the parts were built, they were removed from the stereolithography machine, washed with tri(propyleneglycol)methyl ether ("TPM") and isopropanol, dried in laboratory hood and then placed in a commercially available UV postcuring apparatus ("PCA" sold by 3-D Systems). The PCA apparatus uses 14 tubular florescent lamps; seven of them are TLK40W/3 type emitting UV radiation in 400-440 nm range and other seven are TLK40W/5 type emitting in 300-460 nm. The parts were subjected to approximately 30-60 minutes of UV radiation at room temperature in the PCA.

Parts were building from Example compositions described above. Parts of various geometries were built by stereolithography using the compositions of Example 1, Comparative Example 2A, Example 2B and Comparative Example 3. They are:
a) Tensile coupons (dogbone shape)
b) Squares and rectangles of various dimensions
c) "Window panes"
d) "Bridges"
e) Cantilevers
f) "H-bars"
g) "BMW automotive clips" h) Trapped volume part

All of the above mentioned parts were not built for each and every composition. After building, the parts were either stored in laboratory/office environment with general lighting or in a climate controlled laboratory at approximately 23 °C and 50 % relative humidity. Color and clarity comparisons were done by visual observation and by the test methods outlined below.

### Visual Observation of Color and Clarity by Human Eye

Large sample blocks of size 80 mm x 90 mm x 12.5 mm were prepared on the laboratory stereolithography equipment previously described to inspect for color and clarity using the human eye. No finishing was required.

### UV-Vis Transmission Test Method

The samples created for UV-Vis transmission spectroscopy were 1 cm W × 1 cm T × 5 cm L (0.5" W × 0.5" T × 2" L). This sample size is approximately the size of a 10 mm cuvette commonly used for UV-Vis spectroscopy. Each sample was polished using the following method:
Two opposite long sides of each sample were wet sanded with water using an increasing grit number of sequence (150, 240, 500, 800, 1000, 1200, 1500, and 2000). Care was taken to ensure that the sanded surfaces remained flat and even. Sandpaper is water proof Silicon Carbide from Carborundum Abrasives North America. The samples were then washed with water and buffed on a Baldor® electric wheel buffer with soft polishing wheel using Novus liquid #2 Fine Scratch Remover #PC-20 available from Novus Inc. to give a mirror finish.

The polished parts were then analyzed using a Perkin Elmer Lambda 900 UV-Vis-NIR Spectrophotometer with UV-Winlab Software version 3.00.03. Samples were selected as to not have any internal defects (air bubbles, fractures, inclusions, etc.) and to be of finished dimensions of 12.5mm x 12.5 mm x 50mm +/- 0.5mm. The sample was then placed into the sample holder of the spectrophotometer with the sample oriented so that the UV-Vis beam passed through the two polished sides of the sample. The rear blank cell was left empty and the background/zero used was ambient air. Each sample was then analyzed for %transmission from 400nm - 850 nm.

For Comparative Example 2 (acrylate-vinyl amide only composition) and Example 2B there was a revised UV-VIS test method as follows: UV-Vis transmission method was adjusted due to inability to polish low modulus articles made using a liquid radiation curable resin comprising an acrylate-vinyl amide formula. For this example, liquid photopolymer was placed into a 10mm UV grade polymethylmethacrylate (PMMA) cuvette available from VWR. The liquid was filled until ~lmm from the top of the cuvette. The entire sample was then placed into a 60° C oven for approximately 30 minutes to de-bubble. The entire sample was then placed into the UV Post Cure Apparatus (PCA), apparatus is as previously described, for 10 minutes and cured to solid. The sample was allowed to cool to room temperature. This sample was then measured in the UV-Vis Spectrophotometer as previously discussed, with the exception that the background/blank was an empty PMMA cuvette.

### Colorimetry Test Method

Colorimetry samples created were 5.1 cm × 5.1 1 cm (2.0" × 2.0") square with thickness of 3.18 mm (0.125"). The samples were prepared by removing support structures and lightly wet sanding the residual support on the bottom of each sample with water using 600 grit sand-paper. The samples were then washed with isopropanol to remove dust and debris.

Each colorimetry sample was then analyzed using a MacBeth® ColorEye 7000 spectrophotometer with Optiview® version 1.6 software, available from Kollmorgen Instrument Corporation©. A white tile reference standard #XLO994 available from Greetag-Macbeth was used to both calibrate the instrument and used as a backing tile behind the sample. The samples were run using the following parameters:
"CIE Lab" Program
10° Observation
D65 Illuminant

The spectrophotometer was calibrated as stated using the white tile reference. Once the machine was calibrated, a sample was placed on the colorimetry port with the top surface (smooth) of the sample facing the open port, with the white tile used as a background behind the sample. The machine then executed three measurements on the sample, and the L*a*b* values were recorded. This was performed with three samples and the average of the three L*a*b* values recorded.

**Table of Results of Example Evaluation:**

| **Example** | **Visual Observation of Color and Clarity** | **Max Transmission (%) UV-Visible (450-500nm)** | **b* Value CIELAB, Colorimetry** |
|---|---|---|---|
| 1 | Clear, no color | 77 | +1.056 |
| Comparative Example 2A | Clear, light yellow color | 64.5 | +3.81 |
| 2B | Clear, no color | 68 | +1.609 |
| Comparative Example 3 | Slight haze, slight blue color (darker blue on the sides of the part) | 64 | +2.88 |

While the invention has been described in detail and with reference to specific embodiments thereof, it will be apparent to one of ordinary skill in the art that various changes and modifications can be made therein within the scope of the appended claims.

## Claims

1. A liquid radiation curable resin comprising:
a) one or more di- or multi-functional acrylates;
b) one or more epoxy compounds, wherein at least one of said epoxy compounds is selected from the group consisting of cycloaliphatic epoxy compounds, hydrogenated bisphenol A diglycidylether and mixtures thereof;
c) a free radical photoinitiator;
d) a cationic photoinitiator; and
e) a color masking agent selected from the group consisting of blue, violet, red, yellow, orange and green pigments;
wherein said liquid radiation curable resin, when cured as described herein, has the following properties
i) a clarity and transmittance of greater than 67 % as measured by UV-Visible spectrophotometer in the 400-500 nm range; and
ii) a lack of color as measured by a b* value of between minus 0.5 and positive 2.5 in the CIELAB color space using a spectrophotometer in the visible wavelengths of 400-750 nm.

2. The liquid radiation curable resin composition of claim 1, further comprising one or more additives selected from the group consisting of
i) light stabilizer/UV absorbers;
ii) antioxidants;
iii) acid stabilizers;
iv) wetting agents;
v) air release agents.

3. A liquid radiation curable resin comprising:
a) an acrylate component, wherein the acrylate component is selected from the group consisting of one or more mono, di- or multi-functional acrylates and one or more urethane acrylate oligomers;
b) a free radical photoinitiator; and
c) a color masking agent selected from the group consisting of blue, violet, red, yellow, orange and green pigments;
wherein said liquid radiation curable resin, when cured as described herein, has the following properties
i) a clarity and transmittance of greater than 67 % as measured by UV-Visible spectrophotometer in the 400-500 nm range; and
ii) a lack of color as measured by a b* value of between minus 0.5 and positive 2.5 in the CIELAB color space using a spectrophotometer in the visible wavelengths of 400-750 nm.

4. The liquid radiation curable resin composition of claim 3, further comprising one or more additives selected from the group consisting of
i) light stabilizer/UV absorbers;
ii) antioxidants;
iii) wetting agents;
iv) air release agents.

5. The liquid radiation curable resin of any one of claims 1-4, further comprising an oxetane.

6. The liquid radiation curable resin of any one of claims 1-5, further comprising one or more hydroxyl-functional compounds.

7. The liquid radiation curable resin of any one of claims 1-6 wherein the measured clarity and transmittance is greater than 70 % as measured by UV-Visible spectrophotometer in the 400-500 nm range.

8. The liquid radiation curable resin of any one of claims 1-6 wherein there is a lack of color as measured by a b* value of between zero and positive 2.5 in the CIELAB color space using a spectrophotometer in the visible wavelengths of 400-750 nm.

9. The liquid radiation curable resin of claim 1 or 3, wherein the color masking agent comprises at least one pigment selected from the group consisting of: phthalocyanine blue, alkali blue, ultramarine blue, indanthrene blue, benzimidazolone dioxazine blue, carbazole violet, dioxazine violet, dioxazine violet B, quinacridone violet, perylene violet, naphthol red, carmine F.B., diazo yellow GRX, isoindoline yellow, permanent orange G, fast orange F2G, and phthalocyanine green.

10. The liquid radiation curable resin of claim 1 or 3, wherein the color masking agent is selected from the group of blue pigments and violet pigments.

11. The liquid radiation curable resin of claim 10, wherein the color masking agent comprises at least one pigment selected from the group consisting of: phthalocyanine blue, alkali blue, ultramarine blue, indanthrene blue, benzimidazolone dioxazine blue, carbazole violet, dioxazine violet, dioxazine violet B, quinacridone violet, and perylene violet.

12. A clear and colorless, three-dimensional stereolithography article made from the liquid radiation curable resin of any one of claims 1-6.

## Patentansprüche

1. Flüssiges strahlungshärtbares Harz, umfassend:
a) ein oder mehrere di- oder multifunktionelle Acrylate;
b) eine oder mehrere Epoxidverbindungen, wobei mindestens eine der Epoxidverbindungen aus der Gruppe bestehend aus cycloaliphatischen Epoxidverbindungen, hydriertem Bisphenol-A-diglycidylether und Mischungen davon ausgewählt ist;
c) einen radikalischen Photoinitiator;
d) einen kationischen Photoinitiator und
e) ein Farbmaskierungsmittel aus der Gruppe bestehend aus Blau-, Violett-, Rot-, Gelb-, Orange- und Grünpigmenten;
wobei das flüssige strahlungshärtbare Harz bei Härtung wie hierin beschrieben die folgenden Eigenschaften aufweist:
i) eine Klarheit und Durchlässigkeit von mehr als 67% gemäß Messung mit einem UV-Vis-Spektralphotometer im Bereich von 400-500 nm und
ii) ein Fehlen von Farbe gemäß Messung durch einen b*-Wert zwischen minus 0,5 und positiv 2,5 im CIELAB-Farbraum unter Verwendung eines Spektralphotometers bei den sichtbaren Wellenlängen von 400-750 nm.

2. Flüssige strahlungshärtbare Harzzusammensetzung nach Anspruch 1, ferner umfassend ein oder mehrere Additive aus der Gruppe bestehend aus
i) Lichtschutzmitteln/UV-Absorbern;
ii) Antioxidantien;
iii) Säurestabilisatoren;
iv) Netzmitteln;
v) Entlüftungsmitteln.

3. Flüssiges strahlungshärtbares Harz, umfassend:
a) eine Acrylat-Komponente, wobei die Acrylat-Komponente aus der Gruppe bestehend aus einem oder mehreren mono-, di- oder multifunktionellen Acrylaten und einem oder mehreren Urethanacrylat-Oligomeren ausgewählt ist;
b) einen radikalischen Photoinitiator und
c) ein Farbmaskierungsmittel aus der Gruppe bestehend aus Blau-, Violett-, Rot-, Gelb-, Orange- und Grünpigmenten;
wobei das flüssige Strahlungshärtbare Harz bei Härtung wie hierin beschrieben die folgenden Eigenschaften aufweist:
i) eine Klarheit und Durchlässigkeit von mehr als 67% gemäß Messung mit einem UV-Vis-Spektralphotometer im Bereich von 400-500 nm und
ii) ein Fehlen von Farbe gemäß Messung durch einen b*-Wert zwischen minus 0,5 und positiv 2,5 im CIELAB-Farbraum unter Verwendung eines Spektralphotometers bei den sichtbaren Wellenlängen von 400-750 nm.

4. Flüssige strahlungshärtbare Harzzusammensetzung nach Anspruch 3, ferner umfassend ein oder mehrere Additive aus der Gruppe bestehend aus
i) Lichtschutzmitteln/UV-Absorbern;
ii) Antioxidantien;
iii) Netzmitteln;
iv) Entlüftungsmitteln.

5. Flüssiges strahlungshärtbares Harz nach einem der Ansprüche 1-4, ferner umfassend ein Oxetan.

6. Flüssiges strahlungshärtbares Harz nach einem der Ansprüche 1-5, ferner umfassend eine oder mehrere hydroxylfunktionelle Verbindungen.

7. Flüssiges strahlungshärtbares Harz nach einem der Ansprüche 1-6, wobei die gemessene Klarheit und Durchlässigkeit mehr als 70% gemäß Messung mit einem UV-Vis-Spektralphotometer im Bereich von 400-500 nm beträgt.

8. Flüssiges strahlungshärtbares Harz nach einem der Ansprüche 1-6, wobei ein Fehlen von Farbe gemäß Messung durch einen b*-Wert zwischen null und positiv 2,5 im CIELAB-Farbraum unter Verwendung eines Spektralphotometers bei den sichtbaren Wellenlängen von 400-750 nm vorliegt.

9. Flüssiges strahlungshärtbares Harz nach Anspruch 1 oder 3, wobei das Farbmaskierungsmittel mindestens ein Pigment aus der Gruppe bestehend aus Phthalocyaninblau, Alkaliblau, Ultramarinblau, Indanthrenblau, Benzimidazolondioxazinblau, Carbazolviolett, Dioxazinviolett, Dioxazinviolett B, Chinacridonviolett, Perylenviolett, Naphtholrot, Karmin F.B., Diazogelb GRX, Isoindolingelb, Permanentorange G, Fast Orange F2G und Phthalocyaningrün umfasst.

10. Flüssiges strahlungshärtbares Harz nach Anspruch 1 oder 3, wobei das Farbmaskierungsmittel aus der Gruppe bestehend aus Blaupigmenten und Violettpigmenten ausgewählt ist.

11. Flüssiges strahlungshärtbares Harz nach Anspruch 10, wobei das Farbmaskierungsmittel mindestens ein Pigment aus der Gruppe bestehend aus Phthalocyaninblau, Alkaliblau, Ultramarinblau, Indanthrenblau, Benzimidazolondioxazinblau, Carbazolviolett, Dioxazinviolett, Dioxazinviolett B, Chinacridonviolett und Perylenviolett umfasst.

12. Klarer und farbloser, dreidimensionaler Stereolithographieartikel, hergestellt aus dem flüssigen strahlungshärtbaren Harz nach einem der Ansprüche 1-6.

## Revendications

1. Résine liquide durcissable par rayonnement comprenant :
a) un ou plusieurs acrylates bi- ou multifonctionnels ;
b) un ou plusieurs composés époxy, au moins un desdits composés époxy étant choisi dans le groupe constitué par les composés époxy cycloaliphatiques, l'éther diglycidylique de bisphénol A hydrogéné et les mélanges de ceux-ci ;
c) un photoinitiateur radicalaire ;
d) un photoinitiateur cationique ; et
e) un agent de masquage de couleur choisi dans le groupe constitué par les pigments bleus, violets, rouges, jaunes, orange et verts ;
ladite résine liquide durcissable par rayonnement, lorsqu'elle est durcie comme décrit dans les présentes, ayant les propriétés suivantes :
i) une clarté et transmittance de plus de 67 % telle que mesurée avec un spectrophotomètre UV-visible dans la gamme de 400-500 nm ; et
ii) une absence de couleur telle que mesurée par une valeur b* entre moins 0,5 et plus 2,5 dans l'espace de couleur CIELAB en utilisant un spectrophotomètre dans les longueurs d'onde visibles de 400-750 nm.

2. Composition de résine liquide durcissable par rayonnement de la revendication 1, comprenant en outre un ou plusieurs additifs choisis dans le groupe constitué par
i) les photostabilisants/absorbeurs d'UV ;
ii) les antioxydants ;
iii) les stabilisants aux acides ;
iv) les agents mouillants ;
v) les agents de désaération.

3. Résine liquide durcissable par rayonnement comprenant :
a) un constituant acrylate, le constituant acrylate étant choisi dans le groupe constitué par un ou plusieurs acrylates mono-, bi- ou multifonctionnels et un ou plusieurs oligomères d'acrylate d'uréthane ;
b) un photoinitiateur radicalaire ; et
c) un agent de masquage de couleur choisi dans le groupe constitué par les pigments bleus, violets, rouges, jaunes, orange et verts ;
ladite résine liquide durcissable par rayonnement, lorsqu'elle est durcie comme décrit dans les présentes, ayant les propriétés suivantes :
i) une clarté et transmittance de plus de 67 % telle que mesurée avec un spectrophotomètre UV-visible dans la gamme de 400-500 nm ; et
ii) une absence de couleur telle que mesurée par une valeur b* entre moins 0,5 et plus 2,5 dans l'espace de couleur CIELAB en utilisant un spectrophotomètre dans les longueurs d'onde visibles de 400-750 nm.

4. Composition de résine liquide durcissable par rayonnement de la revendication 3, comprenant en outre un ou plusieurs additifs choisis dans le groupe constitué par
i) les photostabilisants/absorbeurs d'UV ;
ii) les antioxydants ;
iii) les agents mouillants ;
iv) les agents de désaération.

5. Résine liquide durcissable par rayonnement de l'une quelconque des revendications 1 à 4, comprenant en outre un oxétane.

6. Résine liquide durcissable par rayonnement de l'une quelconque des revendications 1 à 5, comprenant en outre un ou plusieurs composés hydroxyfonctionnels.

7. Résine liquide durcissable par rayonnement de l'une quelconque des revendications 1 à 6 dans laquelle la clarté et transmittance mesurée est supérieure à 70 % telle que mesurée avec un spectrophotomètre UV-visible dans la gamme de 400-500 nm.

8. Résine liquide durcissable par rayonnement de l'une quelconque des revendications 1 à 6 dans laquelle il y a une absence de couleur telle que mesurée par une valeur b* entre zéro et plus 2,5 dans l'espace de couleur CIELAB en utilisant un spectrophotomètre dans les longueurs d'onde visibles de 400-750 nm.

9. Résine liquide durcissable par rayonnement de la revendication 1 ou 3, dans laquelle l'agent de masquage de couleur comprend au moins un pigment choisi dans le groupe constitué par : le bleu de phtalocyanine, le bleu alcalin, le bleu ultramarin, le bleu d'indanthrène, le bleu de benzimidazolone-dioxazine, le violet de carbazole, le violet de dioxazine, le violet de dioxazine B, le violet de quinacridone, le violet de pérylène, le rouge de naphtol, le carmin F.B., le jaune diazoïque GRX, le jaune d'isoindoline, l'orange permanent G, l'orange rapide F2G, et le vert de phtalocyanine.

10. Résine liquide durcissable par rayonnement de la revendication 1 ou 3, dans laquelle l'agent de masquage de couleur est choisi dans le groupe des pigments bleus et des pigments violets.

11. Résine liquide durcissable par rayonnement de la revendication 10, dans laquelle l'agent de masquage de couleur comprend au moins un pigment choisi dans le groupe constitué par : le bleu de phtalocyanine, le bleu alcalin, le bleu ultramarin, le bleu d'indanthrène, le bleu de benzimidazolone-dioxazine, le violet de carbazole, le violet de dioxazine, le violet de dioxazine B, le violet de quinacridone, et le violet de pérylène.

12. Article de stéréolithographie tridimensionnel transparent et incolore, fabriqué à partir de la résine liquide durcissable par rayonnement de l'une quelconque des revendications 1 à 6.
